(19)

**Europäisches Patentamt**
**European Patent Office**
**Office européen des brevets**

(11)  **EP 2 378 444 B1**

(12)  # EUROPÄISCHE PATENTSCHRIFT

(45) Veröffentlichungstag und Bekanntmachung des Hinweises auf die Patenterteilung:
**29.07.2015  Patentblatt 2015/31**

(51) Int Cl.:
*G06F 17/50* $^{(2006.01)}$

(21) Anmeldenummer: **10159805.0**

(22) Anmeldetag: **13.04.2010**

(54) **Verfahren, Vorrichtung und Computerprogrammprodukt zur Bestimmung eines elektromagnetischen Nahfeldes einer Feldanregungsquelle eines elektrischen Systems**

Method, device and computer program product for determining an electromagnetic near field of a field excitation source for an electrical system

Procédé, dispositif et produit de programme informatique destinés à la détermination d'un champ de proximité électromagnétique d'une source d'excitation de champ d'un système électrique

(84) Benannte Vertragsstaaten:
**AT BE BG CH CY CZ DE DK EE ES FI FR GB GR HR HU IE IS IT LI LT LU LV MC MK MT NL NO PL PT RO SE SI SK SM TR**
Benannte Erstreckungsstaaten:
**AL BA ME RS**

(43) Veröffentlichungstag der Anmeldung:
**19.10.2011  Patentblatt 2011/42**

(73) Patentinhaber: **CST-Computer Simulation Technology AG**
**64289 Darmstadt (DE)**

(72) Erfinder:
• **Schöberl, Joachim**
  **52134 Herzogenrath (DE)**
• **Koutschan, Christoph**
  **96271 Grub am Forst (DE)**
• **Paule, Peter**
  **4203 Altenberg bei Linz (AT)**

(74) Vertreter: **Spachmann, Holger et al**
**Stumpf Patentanwälte PartGmbB**
**Alte Weinsteige 71**
**70597 Stuttgart (DE)**

(56) Entgegenhaltungen:
• **KEERTI S KONA ET AL: "Implementation of Discontinuous Galerkin (DG) method for antenna applications" ANTENNAS AND PROPAGATION INTERNATIONAL SYMPOSIUM, 2007 IEEE, IEEE, PISCATAWAY, NJ, USA, 1. Juni 2007 (2007-06-01), Seiten 4995-4998, XP031170311 ISBN: 978-1-4244-0877-1**
• **STEPHEN D GEDNEY ET AL: "The Discontinuous Galerkin Finite Element Time Domain Method (DGFETD): A High Order, Globally-Explicit Method for Parallel Computation" 2002 IEEE INTERNATIONAL SYMPOSIUM ON ELECTROMAGNETIC COMPATIBILITY. EMC. SYMPOSIUM RECORD. MINNEAPOLIS, MN, AUG. 19 - 23, 2002; [INTERNATIONL SYMPOSIUM ON ELECTROMAGNETIC COMPATIBILITY], NEW YORK, NY : IEEE, US, 1. Juli 2007 (2007-07-01), Seiten 1-3, XP031128061 ISBN: 978-0-7803-7264-1**
• **GOEDEL N ET AL: "Local timestepping discontinuous Galerkin methods for electromagnetic RF field problems" ANTENNAS AND PROPAGATION, 2009. EUCAP 2009. 3RD EUROPEAN CONFERENCE ON, IEEE, PISCATAWAY, NJ, USA, 23. März 2009 (2009-03-23), Seiten 2149-2153, XP031470217 ISBN: 978-1-4244-4753-4**

- GODEL N ET AL: "Time domain discontinuous Galerkin method with efficient modelling of boundary conditions for simulations of electromagnetic wave propagation" ELECTROMAGNETIC COMPATIBILITY AND 19TH INTERNATIONAL ZURICH SYMPOSIUM ON ELECTROMAGNETIC COMPATIBILITY, 2008. APEMC 2008. ASIA-PACIFIC SYMPOSIUM ON, IEEE, PISCATAWAY, NJ, USA, 19. Mai 2008 (2008-05-19), Seiten 594-597, XP031283991 ISBN: 978-981-08-0629-3
- HARALD SONGORO ET AL: "Keeping Time with Maxwell's Equations" IEEE MICROWAVE MAGAZINE, IEEESERVICE CENTER, PISCATAWAY, NJ, US LNKD- DOI:10.1109/MMM.2010.935779, Bd. 11, Nr. 2, 1. April 2010 (2010-04-01), Seiten 42-49, XP011290479 ISSN: 1527-3342
- IRINA MUNTEANU ET AL: "It's About Time" IEEE MICROWAVE MAGAZINE, IEEESERVICE CENTER, PISCATAWAY, NJ, US LNKD- DOI: 10.1109/MMM.2010.935775, Bd. 11, Nr. 2, 1. April 2010 (2010-04-01), Seiten 60-69, XP011290483 ISSN: 1527-3342
- Christoph Koutschan: "Advanced Applications of the Holonomic Systems Approach", Johannes Kepler Universität Linz Dissertation, September 2009 (2009-09), Retrieved from the Internet: URL: http://www.risc.jku.at/publications/do wnload/ risc_3886/thesisKoutschan.pdf [retrieved on 2011-04-13]
- DATABASE INSPEC [Online] THE INSTITUTION OF ELECTRICAL ENGINEERS, STEVENAGE, GB Inspec No. 7435812, 01 September 2002 HESTHAVEN J S ET AL: 'Nodal high-order methods on unstructured grids. I. Time-domain solution of Maxwell's equations' Database accession no. 7435812 & Journal of Computational Physics Academic Press USA, vol. 181, no. 1 , pages 186-221, ISSN: 0021-9991, DOI: DOI:10.1006/JCPH.2002.7118

**Beschreibung**

STAND DER TECHNIK

Die vorliegende Erfindung betrifft ein Verfahren, eine Vorrichtung und ein Computerprogrammprodukt zur Bestimmung eines elektromagnetischen Nahfeldes einer Feldanregungsquelle eines elektrischen Systems, insbesondere für die Analyse und/oder Optimierung einer Antennenabstrahlung, eines Übersprechproblems, einer Signalreflexion/-transmission, eines Streufeldes, eines Einstrahlproblems oder dergleichen.

Hierzu wird das elektromagnetische System innerhalb einer in N Partitionen aufgeteilten Betrachtungsdomäne betrachtet.

Aus dem Stand der Technik sind Verfahren bekannt, um ein elektromagnetisches Nahfeld einer Feldanregungsquelle eines elektrischen Systems ohne Anwendung zu bestimmen, insbesondere für die Optimierung einer Bauteileentwicklung elektromagnetischer Systeme oder zur Optimierung gewünschter elektromagnetischer Eigenschaften, wie Abstrahlverhalten, Ausstrahlrichtungsoptimierung, Unterdrückung von Nebensprechen, Optimierung einer Transmission oder Reflexion von elektromagnetischen Wellen, Minimierung eines Streufeldes oder dergleichen. Zur Bestimmung der Felder sind auf der einen Seite praktische Versuchsaufbauten und Messvorrichtungen bekannt, die mittels elektromagnetischer Sensoren, beispielsweise Antennen, Hall-Sensoren, Feldstärkesensoren oder Ähnliches, elektromagnetische Felder, insbesondere im Hochfrequenzbereich, aber auch im Niederfrequenzbereich messen können, wobei beispielsweise bei Bestimmung einer Antennenabstrahlcharakteristik eine Messsonde mechanisch um ein betrachtetes Bauteil herumgeführt wird und in bestimmten Abständen Messungen der abgestrahlten RF-Leistung vorgenommen werden.

Zur messtechnischen Optimierung eines elektromagnetischen Bauteils oder Systems müssen allerdings eine Reihe von Versuchsaufbauten mit geänderten Spezifikationen gebaut und vermessen werden. Mit steigender Computerleistung und entsprechender Entwicklung im Bereich der theoretischen/numerischen Feldtheorie lassen sich in den letzten Jahren vergleichbare Analysen und Optimierungen elektromagnetischer Systeme innerhalb einer Modelldomäne durchführen. Hierzu wird ein elektromagnetisches System, beispielsweise eine Antenne eines Mobilfunktelefons, eine Außenhülle eines Flugzeugs, eine Wellenleiterstruktur oder signalführende Leitungsverbindungen einer Platine (PCB - Printed Circuit Board) oder ähnliche elektromagnetische Systeme in einem numerischen Modell abgebildet, und die hierauf anzuwendenden Maxwellschen-Gleichungen mittels Optimierungsverfahren gelöst.

Gegenüber messtechnischen Analyse- und Optimierungsverfahren bieten solche rechnergestützten Verfahren den Vorteil einer schnellen Analyse einer Vielzahl von Bauteilen, wobei einzelne Bauteilparameter wie Materialeigenschaften, mechanische Dimensionen, Anregungsfrequenzen oder Ähnliches im Rahmen einer Optimierungsrechnung variiert und somit eine große Vielzahl verschiedener elektromagnetischer Systeme hinsichtlich einer oder mehrerer Optimierungsstrategien untersucht werden können. Rechnergestützte Feldbestimmungen unterscheiden sich grundsätzlich in Frequenzbereichs- und Zeitbereichsbestimmungen. Frequenzbereichsbestimmungen betrachten ein elektromagnetisches System bei einer oder mehreren festen Frequenzen, wobei zur Bestimmung der elektromagnetischen Felder ein harmonischer Ansatz gewählt werden kann. Zeitbereichsbetrachtungen bestimmen den zeitlichen Verlauf eines Anregungssignals und können eine Vielzahl von Frequenzkomponenten eines zeitlichen Signals sowie das Verhalten von Impulsen, beispielsweise bei Übersprechen benachbarter elektrischer Leitungen auf einem PCB, analysieren.

Aus dem Stand der Technik sind numerische Berechnungsverfahren auf strukturierten Partitionen, die als Gitterzellen bezeichnet werden, bekannt, stellvertretend sind Hexaedergitter oder Tetraedergitter zu erwähnen, wobei wesentliche Vertreter solcher elektromagnetischer Bestimmungsverfahren die Finite-Differenzen-Methode (FD), die Finite-Integrations-Methode (FIT) und die Finite-Elemente-Methode (FEM) sind.

Der Berechnungsaufwand der verschiedenen Verfahren spielt eine wesentliche Rolle beim Einsatz dieser Verfahren. Mit Berechnungsaufwand und Bestimmungsaufwand werden im Folgenden, soweit nicht anders beschrieben, der Speicheraufwand für die Bestimmung der Nahfeldlösung sowie der zeitliche Rechenaufwand pro Berechnung einer räumlichen und/oder zeitlichen Ableitung, die z.B. in einem Zeitschrittverfahren oder einem iterativen Verfahren berechnet werden müssen, bezeichnet.

Die Finite-Differenzen- und die Finite-Integrations-Methode lassen sich bevorzugt auf Hexaedergittern umsetzen und weisen im Wesentlichen eine lineare Komplexität auf, d.h. eine Erhöhung der Anzahl von Gitterzellen bzw. Vergrößerung des elektromagnetischen Systems in einer Richtung führt zu einem linearen Anstieg des Berechnungsaufwands bezüglich einer Anzahl N betrachteter Partitionen (Gitterzellen). Ansätze, die auf der Finiten-Elemente-Methode beruhen, werden in vielen Fällen auf sogenannten unstrukturierten Tetraederzellen umgesetzt, wobei der Bestimmungsaufwand superlinear, oft quadratisch oder höher, mit der Anzahl der betrachteten Unbekannten wächst. Zur Erhöhung der Genauigkeit einer Bestimmungslösung kann die Größe der verwendeten Partitionen, insbesondere die räumliche Dimension einer Gitterzelle verringert werden, dies bezeichnet man als sogenannte $h$-Verfeinerung. Daneben lässt sich die Approximationsgenauigkeit der verwendeten Ansatzfunktionen erhöhen, dies wird als $p$-Verfeinerung bezeichnet, wobei bei Verwendung von Polynomen als Ansatzfunktionen der Term $p$ den maximalen Grad der Ansatzpolynome beschreibt. Die Methode der Finiten Integration wurde als Erstes von T. Weiland in dem Artikel "Eine Methode zur Lösung der Maxwellschen-Gleichungen für sechskomponentige Felder auf Diskreter Basis", Electronics and Communication (AEÜ), Volume 31(3), März 1977, Seiten 116 bis 120, vorgestellt. Die Methode der Finiten Differenzen im Zeitbereich wurde zunächst von Kane Yee in dem Artikel "Numerical Solution of Initial Boundary Value Problems Involving Maxwell's Equations in Isotropic Media", Antennas and Propagation, IEEE Transactions, Volume 14, Seiten 302 bis 307, im Jahre 1966 vorgestellt. Die Methode der Finiten Elemente und speziell der gemischten bzw. Kantenelemente wie von J. C. Nédélec in dem Artikel "Mixed Finite Elements in R^3", Numerische Mathematik, Volume 35, Seiten 315-341 im Jahre 1980 beschrieben ermöglicht im Gegensatz zu den vorgenannten Methoden, die lediglich an Stützstellen auf dem Gitterfeld Feldwerte bestimmen, eine approximierte Lösung im gesamten Betrachtungsgebiet für die Maxwellschen-Gleichungen zumeist auf Basis einer Galerkin-Formulierung. Jedoch sind momentan nur Methoden bekannt, die eine aufwendige Invertierung eines globalen Gleichungssystems erfordern und speziell bei Erhöhung des Polynomgrades p eine superlineare Bestimmungskomplexität aufweisen. Diese Methoden sind somit für elektromagnetisch große Betrachtungsdomänen nicht geeignet.

Strukturierte Gitter, beispielsweise Hexaedergitter zeichnen sich durch eine eindeutige vorbekannte Nachbarschaftsbeziehung der Gitterzellen aus. Im Gegensatz hierzu müssen Nachbarschaftsbeziehungen von unstrukturierten Gitterzellen gesondert abgelegt und beachtet werden. Nachteilig an einer Diskretisierung elektromagnetischer Systeme mittels strukturierten Zellen ist die Unflexibilität der Gittergenerierung, wobei insbesondere gekrümmte Oberflächen von Bauteilen oder Strukturen sehr schwierig mittels strukturierter Gitter abgebildet werden können. Unstrukturierte Gitter lassen eine wesentlich bessere Abbildung von gekrümmten Oberflächen elektromagnetischer Systeme zu, jedoch sind aufgrund des höheren Berechnungsaufwand bei gleicher Größe der Betrachtungsdomäne natürliche Grenzen hinsichtlich der Komplexität eines elektromagnetischen Systems gesetzt.

In der Veröffentlichung Keerti S. Kona et. al: "Implementation of a Discontinuous Galerkin (DG) Method for Antenna Applications", Antennas and Propagation International Symposium, 2007 IEEE, IEEE, Piscataway, NJ, USA, 1. Juni 2007, Seiten 4995-4998, ISBN: 978-1-4244-0877-1 wird eine integrale Variante der Maxwellschen-Gleichungen zur Lösung eines elektromagnetichen Feldproblems beschrieben, wobei Testfunktionen des Galerkin-Ansatzes als Basisfunktionen zur Darstellung der Felder dienen. Die Basisfunktionen in der verwendeten Implementierung sind als $v_L^i(x) = [x-x_i]^a \times [y-y_i]^b \times [z-z_i]^c$ für $0 < a + b + c \leq N$, definiert, wozu $N$ die Ordnung des Polynoms darstellt.

Eine Anwendung des Verfahrens führt nicht auf eine lineare, sondern auf eine mindestens quadratische numerische Komplexität bei Erhöhung des Polynomgrades.

Aus Stephen D. Gedney et al: "The Discontinuous Galerkin Finite Element Time Domain Method (DGFETD): A High Order, Globally-Explicit Method for Parallel Computation", 2002 IEEE International Symposium on Electromagnetic Compatibility. EMC. Symposium Record. Minneapolis, MN, Aug. 19-23, 2002; Seiten 1-3, ISBN: 978-0-7803-7264-1 geht ebenfalls gewöhnliche FEM-Ansatzfunktionen hervor. Eine Darstellung der Komplexität einer $h$- oder $p$-Verfeinerung fehlt, so dass jeglicher Hinweis auf eine im Wesentlichen lineare Komplexität nicht auffindbar ist.

In Goedel N. et al "Local timestepping discontinuous Galerkin methods for electromagnetic Galerkin methods for electromagnetic RF field problems", Antennas and Propagation, 2009. EUCAP 2009, 3rd European Conference on, IEEE, Piscataway, NJ, USA, 23. März 2009, Seiten 2149-2153, ISBN: 978-1-4244-4753-4 wird ein gattungsähnliches diskontinuierliches Galerkin-Verfahren beschrieben, bei dem ein lokales Zeitschritt-Verfahren auf Basis einer expliziten Runge-Kutta-Methode verwendet wird. Der Schwerpunkt des Verfahrens beruht auf einer modifizierten zeitlichen Integrationsvorschrift, wobei die Druckschrift über die Art der räumlichen Ansatzfunktionen zur Bestimmung der Felder schweigt.

Daneben betrifft Goedel N. et al "Time domain discontinuous Galerkin method with efficient modelling of boundary conditions for simulations of electromagnetic wave propagation", Electromagnetic Compatibility and 19th International Zürich Symposium on Electromagnetic Compatibility, 2008, APEMC 2008, Asia-Pacific Symposium On, IEEE, Piscataway, NJ, USA, 19. Mai 2008, Seiten 594-597, ISBN 978-981-08-0629-3 ein gattungsähnliches Besimmungsverfahren, wobei keine Aussagen über die numerische Komplexität getroffen werden.

Des weiteren geht aus Harald Songoro et al: "Keeping Time with Maxwell's Equations", IEEE Microwave Magazine, IEEE Service Center, Piscataway, NJ, USm 1. April 2010, Seiten 42-49, ISSN: 1527-3342 eine weitere Variante eines diskontinuierlichen Galerkin-Ansatzes hervor, wobei gewöhnliche FEM-Basis und Testfunktionen in einer Partition angesetzt werden.

Die vorgenannten Veröffentlichungen offenbaren bekannte diskontinuierliche Galerkin-Funktionen, die aus einem Ansatz ähnlich dem von Jan S. Hesthaven und Tim Warburton bekannt sind. Diese bekannten Ansätze beruhen auf Funktionen und Verfahren, die eine superlineare Komplexität in der Anzahl der Ansatzfunktionen, insbesondere in einer Komplexität von mindestens $O(x^{2d})$ für $x$ = Polynomgrad $p$ oder Anzahl Partitionen $N$ sowie $d$-Dimensionen zur Berechnung der räumlichen und/oder zeitlichen Ableitung aufweisen.

Die Dissertationsschrift von Christop Koutschan mit dem Titel "Advanced Applications of the Holonomic System Approach", Johannes Kepler Unversität Linz, September 2009 schlägt vor, eine Gradientenbeziehung durch Anwendung von Legendre- oder Jacobi-Polynome bereitzustellen, wobei eine Summation von Ansatzfunktionen gewichtet mit Ansatzfunktionen zur Darstellung einer räumlichen Ableitung verwendet werden kann.

Im Beitrag von J. S. Hesthaven et al., "Nodal high-order methods on unstructured grids. I. Time-domain solution of Maxwell's equations" vom 1. September 2002, erschienen im Journal of Computational Physics, Academic Press USA, Bd. 181, Nr. 1, Seiten 186-221, ISSN: 0021-9991, DOI: 10.1006/JCPH.2002.7118 beschreibt ein Zeitbereichsverfahren zur Lösung der Maxwellschen Gleichungen, dass auf unstrukturierten Gittern umgesetzt werden kann.

Somit ergibt sich aus dem Stand der Technik das Problem, zur Analyse und Optimierung eines elektrischen Systems, insbesondere hinsichtlich einer Antennenabstrahlung, eines Übersprechproblems, einer Signalreflexion oder - transmission, der Bestimmung eines Streufeldes (RCS-Rechnung - Radar Cross Section), einer Antenneneinstrahlung oder ähnliches ein Bestimmungsverfahren vorzuschlagen, mit dessen Hilfe die Maxwellschen-Gleichungen auf einem unstrukturierten, insbesondere tetraederförmigen, prismenförmigen oder gemischten Gitter berechnet werden können, wobei der Berechnungsaufwand linear mit der Anzahl der zu bestimmenden Unbekannten der Betrachtungsdomäne, also linear bezüglich der Anzahl der Partitionen $N$ ($h$-Verfeinerung) sowie linear mit der Anzahl $M$ der verwendeten Ansatzfunktionen, insbesondere beeinflusst durch die Approximationsqualität der Ansatzfunktionen ($p$-Verfeinerung), wächst.

Dieses Problem wird durch ein Verfahren, eine Vorrichtung und ein Computerprogrammprodukt nach den unabhängigen Ansprüchen gelöst. Vorteilhafte Weiterentwicklungen sind Gegenstand der Unteransprüche.

OFFENBARUNG DER ERFINDUNG

Gemäß eines ersten Aspektes der vorliegenden Erfindung wird ein Verfahren zur Bestimmung eines elektromagnetischen Nahfeldes einer Feldanregungsquelle eines elektrischen Systems insbesondere für die Analyse und Optimierung einer Antennenabstrahlung, eines Übersprechproblems, einer Signalreflexion/-transmission, eines Streufeldes, eines Einstrahlproblems oder dergleichen vorgestellt, das innerhalb einer das System umfassenden und in $N$ Partitionen aufgeteilten Betrachtungsdomäne folgende Schritte ausführt:

- Definition elektrischer und magnetischer Eigenschaften der Materialverteilung des Systems in jeder Partition (Gitterzelle) innerhalb der Betrachtungsdomäne;
- Definition mindestens einer Feldanregungsquelle innerhalb des Systems;
- Bestimmung der elektromagnetischen Nahfeldkomponente innerhalb zumindest einer, insbesondere aller Partitionen, durch Lösen der Maxwellschen-Gleichungen des Nahfeldes unter Berücksichtigung der definierten Materialverteilung und der definierten Feldanregungsquelle.

Dabei wird jede Nahfeldkomponente jeder Partition durch eine Linearposition von $M$ vorbestimmten, holonomen und zueinander bezüglich des L2-Skalarproduktes orthogonalen Ansatzfunktionen $P_i$ gewichtet mit Feldkoeffizienten $v_i$ dargestellt, und die zur Lösung der Maxwellschen-Gleichungen erforderliche räumliche und/oder zeitliche Ableitung der Nahfeldkomponente ist als Linearposition dieser Ansatzfunktionen $P_i$ gewichtet mit Ableitungskoeffizienten $w_i$ bestimmbar. Bei der Ermittlung des elektrischen Nahfeldes wird jeder Koeffizient $w_i$ rekursiv aus einer Menge zuvor bestimmter Feldkoeffizienten $v_i$ und Ableitungskoeffizienten $w_i$ bestimmt, so dass der Bestimmungsaufwand des

Nahfeldes des Systems im Wesentlichen linear zur Anzahl $N$ der Partitionen der Betrachtungsdomäne und zur Anzahl $M$ der in der Linearposition verwendeten Ansatzfunktionen $P_i$ (42) steigt.

Mit anderen Worten betrifft das Verfahren eine bevorzugt rechnergestützte Arbeitsvorschrift zur Bestimmung eines elektromagnetischen Nahfeldes, beispielsweise einer Antennenabstrahlung, einer ebenen Welleneinstrahlung innerhalb eines elektromagnetischen Systems, eines Übersprechverhaltens zwischen benachbarten Leitungen eines PCBs, einer Signalreflexion auf Wellenleitern, beispielsweise beim Übergang von einer Wellenleiterform auf eine andere Wellenleiterform bzw. bei Wechsel des Wellenleitermaterials. Mittels des Verfahrens können mechanische und auch elektrische Eigenschaften des elektrischen Systems schnell und einfach geändert werden, wobei das System in einer Betrachtungsdomäne "diskretisiert" wird. Hierzu werden in der Betrachtungsdomäne $N$ Partitionen eingeführt, die beispielsweise hexaederförmige, tetraederförmige, prismenförmige Gitterzellen oder Ähnliches, auch gemischt, umfassen. In diesen Partitionen (Gitterzellen) werden elektrische und magnetische Eigenschaften der Materialverteilung des Systems definiert, insbesondere Permeabilität $\mu$, Permittivität $\varepsilon$ und Leitfähigkeit $\kappa$. Des Weiteren wird eine Feldanregungsquelle, beispielsweise eine Dipolabstrahlung, der Einfall einer ebenen Welle, die Modenanregung an einem elektromagnetischen Port oder Ähnliches definiert, und die Maxwellschen-Gleichungen werden für alle elektromagnetischen Feldkomponenten innerhalb aller Partitionen gelöst. Zur Bestimmung der Nahfeldkomponenten wird eine Beschreibung jeder Nahfeldkomponente, insbesondere elektrische Feldstärke $E$, dielektrische Flussdichte $D$, magnetische Feldstärke $H$, magnetische Flussdichte $B$, elektrische Stromdichte $J$ gewählt, die sich als Linearposition von $M$ vorbestimmten und zueinander bezüglich des L2-Skalarproduktes orthogonalen Ansatzfunktionen $P_i$ gewichtet mit Feldkoeffizienten $v_i$ darstellen lässt. Die Maxwellschen-Gleichungen benötigen neben der Felddarstellung auch deren zeitliche und/oder räumliche Variation, insbesondere erste Ableitungen $\frac{d}{dt}$, $\text{curl } \vec{X} = \nabla \times \vec{X}$ mit $\nabla = \begin{pmatrix} \frac{d}{dx} \\ \frac{d}{dy} \\ \frac{d}{dz} \end{pmatrix}$, die ebenfalls als Linearposition dieser Ansatzfunktionen $P_i$ gewichtet mit anderen Ableitungskoeffizienten $w_i$ darstellbar ist. Hierbei lassen sich die Ableitungskoeffizienten $w_i$ aus einer Menge zuvor bestimmter Feldkoeffizienten $v_i$ und Ableitungskoeffizienten $w_i$ so bestimmen, dass bei einer Erweiterung der Betrachtungsdomäne (Anzahl N der Partitionen) oder Erhöhung des Approximationsgrades der Linearposition $M$ von Ansatzfunktionen $P_i$ der Bestimmungsaufwand im Wesentlichen linear mit der Anzahl der Partitionen und der Anzahl der Ansatzfunktionen wächst. Somit lässt sich eine speicheroptimierte und schnelle Anwendung von Operatoren, insbesondere der in den Volumen der Partitionen operierenden Gradienten/Rotations (curl)/Divergenz-Operatoren sowie den auf den Rändern der Partitionen operierenden entsprechenden Trace-Operatoren, die zur Kopplung der Feldflüsse benachbarter Partitionen dienen, oder deren Transponierten, sowie der Massenoperatoren und deren Inversen (Materialverknüpfungsoperatoren zur Umwandlung von Feldstärken in Flussdichten/Stromdichten und umgekehrt), erreichen. Ist eine solche Basis von Ansatzfunktionen und eine Formulierung der Gradienten als rekursive Bestimmung aus den Ansatzfunktionen bekannt, so können diese in beliebigen Gittertypen umgesetzt werden, um eine Bestimmung des elektromagnetischen Nahfeldes eines elektrischen Systems vorzunehmen, wobei der Bestimmungsbedarf im Wesentlichen linear mit der Partitionszahl $N$ und der Anzahl der verwendeten Ansatzfunktionen $M$ steigt, so dass eine Erhöhung der Anzahl Gitterzellen $N$ ($h$-Verfeinerung) oder eine Erhöhung der Anzahl $M$ der verwendeten Ansatzfunktionen $P_i$ ($p$-Verfeinerung) nur zu einer im Wesentlichen linearen Verlängerung von Rechenzeit bzw. Rechenaufwand führt. In der Regel werden für bestimmte Gittertypen, insbesondere hexaederförmige, prismenförmig, tetraederförmige oder gemischte Gitter speziell geeignete Ansatzfunktionen gewählt.

Gemäß einer vorteilhaften Ausgestaltung erfolgt die Partitionierung der Betrachtungsdomäne, d.h. die Aufteilung der Betrachtungsdomäne in einzelne Gitterzellen, durch ein unstrukturiertes Gitter, insbesondere ein tetraederförmiges, prismenförmiges Gitter, oder eine Mischform dieser Gitterzellen, die beispielsweise auch Hexaederzellen umfassen kann. Ein unstrukturiertes Gitter lässt sich im Gegensatz zu einem strukturierten Gitter nicht ohne Kenntnis von Nachbarschaftsbeziehungen zu benachbarten Gitterzellen betrachten. Strukturierte Gitter, insbesondere hexaederförmige Gitter oder Gitter in Kugel- oder Zylinderkoordinaten, lassen eine einfache Adressierung einer Gitterzelle mittels dreier Indizes im dreidimensionalen Falle zu. Unstrukturierte Gitter, insbesondere tetraederförmige Gitter, lassen sich nur mit höherem Aufwand unter Betrachtung einer Nachbarschaftsbeziehung zwischen einzelnen Gitterknoten, Gitterflächen und Gitterkanten adressieren. Andererseits ermöglichen unstrukturierte Gitter eine bessere Approximation von Geomtrieoberflächen.

Gemäß einer weiteren vorteilhaften Ausführung erfolgt die Ermittlung jeder elektromagnetischen Nahfeldkomponente mittels eines DG-FEM-Verfahrens (Discontinuous Galerkin Finite Element Method). Die Anwendung eines DG-FEM-Verfahrens für Maxwellsche-Gleichungen zur Berechnung elektromagnetischer Nahfeldkomponenten ist beispielsweise aus Jan S. Hesthaven und Tim Warburton "Nodal Discontinuous Galerkin Methods" - Algorithms, Analysis, and Applications, Springer Science+Business Media, LLC, New York, 2008 bekannt. Jedoch geht aus dieser Beschreibung nicht die Anwendung von orthogonalen Ansatzfunktionen, deren räumliche bzw. zeitliche Ableitung sich aus einer Menge zuvor bestimmter Feld- und Ableitungskoeffizienten rekursiv mit linearer Komplexität bestimmen lässt, insbesondere nicht für gemischte Gitter mit Hexaeder-, Tetraeder- und Prismengitterzellen, hervor. Der dortige Ansatz beruht auf Ansatzfunktionen und Verfahren, die eine superlineare Komplexität in der Anzahl der Ansatzfunktionen, insbesondere eine Komplexität $O(p^{2d})$ für $d$-Dimensionen und einem maximalen Polynomgrad von $p$ der räumlichen und/oder zeitlichen Ableitungen des Bestimmungsverfahrens aufweisen. Eine p-Verfeinerung, dass heißt eine Erhöhung der Anzahl $M$ der superpositionierten Ansatzfunktionen $P_i$ führt damit zu einem superlinearen Anstieg im Berechnungsaufwand. Erfindungsgemäß wird jeder Koeffizient $w_i$ rekursiv aus einer zuvor bestimmten Menge von Koeffizienten $v_j$, $w_j$ ermittelt. Somit lassen sich Koeffizienten $w_i$ aus einem Satz von zuvor bestimmten Komponenten $v_j$, $w_j$, insbesondere bei Zeitbereichsverfahren, in denen ein Zeitschritt nach dem anderen Zeitschritt berechnet wird, aus bereits vorbestimmter Koeffizienten linear rekursiv berechnen. Eine linear rekursive Berechnung bedeutet, dass aktuell zu betrachtende Koeffizienten in einer linearen Verknüpfung und im Wesentlichen unter Zuhilfenahme von Koeffizienten des vorangegangenen Zeitschritts oder einer vorangegangenen Iteration/Näherungslösung bestimmt werden. Somit können Koeffizienten eines nachfolgenden Zeitschritts/Iteration mit linearer Komplexität aus zuvor berechneten Koeffizienten bestimmt werden. Insbesondere können sich für eine 1D Felddarstellung gegebener Nahfeldkomponenten $v(x)$, die sich als Summe der

räumlichen Feldansatzfunktionen $v(x) = \sum_{i=0}^{M-1} v_i P_i(x)$ schreiben lassen, deren räumlichen Ableitungen als

$$\text{grad}[v(x)] = \sum_{i=0}^{M-1} v_i \text{grad}[P_i(x)] = \sum_{i=0}^{M-1} w_i P_i(x)$$ berechnen lassen, wobei die räumlichen Ableitungskoeffizienten $w_i$ rekursiv mit $w_i = f(v_j, w_j)$ berechenbar sind.

Gemäß einer weiteren vorteilhaften Ausgestaltung sind die Ansatzfunktionen $P_i$ als orthogonale Polynome ausgewählt, wobei sich vorteilhafterweise eine Linearposition einer Feldkomponente als $v(x) = \sum_{i=0}^{M-1} v_i P_i(x)$ schreiben lässt, mit $M$ Ansatzpolynomen, wobei der Grad $p$ jedes Ansatzpolynoms $P_i$ gerade $i$ ist. Somit wird jede Ansatzfunktion als Gesamtpolynom des Grades $p=M-1$ beschrieben, wobei eine Erhöhung von $M$ eine Erhöhung des Polynomgrades entspricht, und somt eine $p$-Verfeinerung bewirkt. Solche orthogonalen Polynome können beliebig ausgestaltet sein, bevorzugt werden sie als Legendre-Polynome oder als hierzu allgemeinere Jacobi-Polynome dargestellt. Polynome sind orthogonal, wenn sie auf einem Intervall $[a,b]$ mit einer darauf gegebenen Gewichtsfunktion $\rho(x)$, die Orthogonalitätsbedingungsformel $\int_a^b \rho(x) P_n(x) P_m(x) dx = 0$ für alle $m,n \in N_0$ mit $m \neq n$ erfüllen. Insbesondere Legendre- und Jacobi-Polynome lassen sich rekursiv nach einer einfachen Formel bestimmen und für beliebige Polynomgrade schnell herleiten.

Anlehnend an die obigen Ausführungsbeispiele berechnen sich für eine 1D Felddarstellung bei gegebenen Nahfeldkomponenten als Summe der räumlichen Feldansatzfuntktionen $P_i$ $v(x) = \sum_{i=0}^{M-1} v_i P_i(x)$, deren Ableitungen als

$$\text{grad}[v(x)] = \sum_{i=0}^{M-1} v_i \text{grad}[P_i(x)] = \sum_{i=0}^{M-1} w_i P_i(x)$$, wobei die Koeffizienten $w_i$ rekursiv mit $w_i = f(v_j, w_j)$ berechenbar sind. Insbesondere lassen sich gemäß der obigen Ausgestaltung für alle $i=M-1$ bis 0 und $\hat{v}_M = 0, \hat{v}_{M-1} = v_{M-1}$ die $w_i$ durch die Rekursionsformel $w_i = (2i+1)\hat{v}_{i+1}$ und $\hat{v}_{i-1} := v_{i-1} + \frac{1}{2i+1} w_i$ für $i>0$ bestimmen. Durch eine solche lineare rekursive Formulierung sind neue $w_i$ beispielsweise eines nachfolgenden Zeitschritts oder einer nachfolgenden Iteration aus zuvor bestimmten $w_j$ und $v_j$ bestimmbar.

Insbesondere lassen sich bei dieser Rekursion die Ableitungskoeffizienten $w_i$ in einem Zeitschrittverfahren aus zuvor berechneten Koeffizienten $w_j$, $v_j$ und mittels der Rekursionsformel aus höher oder niederindizierten Komponenten, z.B. $v_{i+1}$, $v_{i-1}$, $w_{i+1}$, $w_{i-1}$, bestimmen. Diese 1D-Darstellung lässt sich auf die Darstellung von 2D- und 3D-Feldkomponenten übertragen. Im 2D- oder 3D-Fall wird die Feldbeschreibung durch eine Tensorformulierung vorgenommen, wobei jeder Tensoreintrag ein vorgenanntes Polynom sein kann.

Gemäß einer vorteilhaften Ausgestaltung bei Verwendung des erfindungsgemäßen Verfahrens in einer Zeitbereichsberechnung können zur Bestimmung der elektromagnetischen Nahfeldkomponenten ein explizites Zeitintegrationsverfahren, insbesondere ein Leapfrog- oder ein Runge-Kutta-Zeitschrittverfahren oder ein implizites Zeitintegrationsverfahren angewendet werden, wobei ein Abbruchkriterium der Zeitintegration die Erreichung einer vorbestimmbaren Anzahl von Zeitschritten und/oder das Erreichen eines vorbestimmbaren Energiefeldwertes oder Ähnliches ist. Ein explizites Integrationsverfahren ermöglicht eine einfache direkte Berechnung der Feldwerte eines nachfolgenden Zeitschritts durch Werte eines oder mehrerer vorangegangener Zeitschritte. Ein implizites Verfahren erfordert hierfür die Lösung eines Gleichungssystems und ist somit mit einem höheren Bestimmungsaufwand verbunden, da kein direkter Update der Feldwerte möglich ist. Ein Leapfrog-Verfahren ist eine einfache Methode zur expliziten numerischen Zeitintegration einer gewöhnlichen Differentialgleichung mittels zeitlich um einen halben Zeitschritt versetzter physikalischer Komponenten, beispielsweise von elektrischen und magnetischen Feldkomponenten, die innerhalb eines Zeitgitters um einen halben Zeitschritt verschoben allokiert sind. So lässt sich beispielsweise eine elektrische Feldstärkenkomponente $E_x^{n+1}$ am Zeitpunkt $(n + 1)\Delta t$ mit Zeitschritt $\Delta t$ aus einer vorherigen elektrischen Feldstärkekomponente $E_x^n$ zum vorherigen Zeitschritt $n$ und aus der räumlichen Ableitung einer magnetischen $H_z$-Feldstärkekomponente zum Zeitschritt $n+1/2$ berechnen mit $E_x^{(n+1)} = E_x^{(n)} + \frac{d}{dx} H_z^{(n+1/2)}$. Runge-Kutta-Verfahren beruhen auf einer abgebrochenen Taylor-Entwicklung einer zeitlichen Ableitung, wobei $E$- und $H$-Feldkomponenten auf dem gleichen Zeitgitter allokiert werden können. Mittels des Einsatzes des Leapfrog- oder Runge-Kutta-Zeitschrittverfahrens lässt sich eine transiente Analyse einer elektromagnetischen Feldentwicklung effizient mit linearer Komplexität des Berechnungsaufwandes der räumlichen und/oder zeitlichen Ableitungen in $N$ und $M$ durchführen, wobei der Berechnungsaufwand für das gesamte Problem bis zu einer festen Endzeit $T$ aufgrund eines Stabilitätskriteriums bezüglich des Zeitschritts superlinear wachsen kann.

Gemäß eines weiteren Aspektes der Erfindung wird eine Vorrichtung zur Anwendung eines Verfahrens nach einem der vorgenannten Verfahrensansprüche vorgeschlagen, um ein elektromagnetisches Nahfeld einer Feldanregungsquelle eines elektrischen Systems zu bestimmen, insbesondere für die Analyse und/oder Optimierung einer Antennenabstrahlung, eines Übersprechproblems, einer Signalreflexion/-transmission, eines Streufeldes, eines Einstrahlproblems oder Ähnliches. Hierzu umfasst die Vorrichtung eine Partitionierungseinrichtung zur Definition einer $N$-teiligen Partition einer Berechnungsdomäne, die das System beinhaltet, und innerhalb derer das Nahfeld bestimmt werden soll; eine Materialverteilungseinrichtung zur Definition elektrischer und magnetischer Eigenschaften der Materialverteilung des Systems in jeder Partition innerhalb der Betrachtungsdomäne; eine Quelleneinrichtung zur Definition mindestens einer Feldanregungsquelle innerhalb des Systems; eine Feldbestimmungseinrichtung zur Bestimmung jeder elektromagnetischen Nahfeldkomponente innerhalb zumindest einer, insbesondere aller Partitionen durch Lösung der Maxwellschen-Gleichungen unter Berücksichtigung der bestimmten Materialverteilung und der bestimmten Feldanregungsquelle. Die Feldbestimmungseinrichtung umfasst eine Komponentenbestimmungseinheit zur Ermittlung einer Linearposition vorbestimmter, holonomer und zueinander bezüglich des L2-Skalarproduktes orthogonaler Ansatzfunktionen $P_i$ gewichtet mit Feldkoeffizienten $v_i$ für jede Nahfeldkomponente und eine Ableitungsbestimmungseinheit zur Bestimmung der für die Lösung der Maxwellschen-Gleichungen erforderlichen räumlichen und/oder zeitlichen Ableitungen jeder Nahfeldkomponente als Linearposition dieser Einsatzfunktionen $P_i$ gewichtet mit Ableitungskoeffizienten $w_i$, wobei die Ableitungsbestimmungseinheit eingerichtet ist, um bei der Bestimmung des elektrischen Nahfeldes jeden Koeffizienten $w_i$ aus einer Menge zuvor bestimmter Feldkoeffizienten $v_j$ und Ableitungskoeffizienten $w_j$ zu bestimmen. Hierdurch steigt der Bestimmungsaufwand des Nahfeldes des Systems im Wesentlichen linear zur Anzahl $N$ der Partitionen der Betrachtungsdomäne und zur Anzahl $M$ der in der Linearposition verwendeten Ansatzfunktionen $P_i$.

Mit anderen Worten umfasst die Vorrichtung eine Partitionierungseinrichtung zur Partitionierung einer Betrachtungsdomäne in $N$ Partitionen, d.h. $N$ Gitterzellen, insbesondere einen Gittergenerator und eine Materialverteilungseinrichtung zur Verteilung der elektrischen und magnetischen Eigenschaften der Materialverteilung des Systems in jeder Partition, so dass Partitionierungseinrichtung und Materialverteilungseinrichtung ein System in einer $N$-partitionierten Betrachtungsdomäne darstellen bzw. diskretisieren können. Eine Quelleneinrichtung dient zur Definition zumindest einer Anregungsquelle für ein elektromagnetisches Feld, beispielsweise eine ebene Welle, eine Dipolabstrahlung, ein eingeprägter Strom, eine Portanregung eines Wellenleiters oder Ähnliches. Eine Feldbestimmungseinrichtung ist eingerichtet, in den Partitionen des Gitters die elektromagnetischen Nahfeldkomponenten durch Lösung der Maxwellschen-Gleichungen zu bestimmen, wobei die Materialverteilung und die definierten Feldanregungsquellen berücksichtigt werden. Die Feldbestimmungseinrichtung kann auf eine Frequenz oder Zeitbereichsbestimmung der elektromagnetischen Felder ausgelegt sein und nutzt zur Ermittlung der elektromagnetischen Nahfeldkomponenten eine Linearposition von orthogonalen Ansatzfunktionen $P_i$, die mit Feldkoeffizienten $v_i$ gewichtet sind, wobei sich die Ableitungen in räumlicher und/oder zeitlicher Hinsicht als weitere Linearposition der Ansatzfunktionen mit Ableitungskoeffizienten $w_i$ darstellen lassen. Die Ableitungskoeffizienten $w_i$ lassen sich aus einer Menge zuvor bestimmter Feldkoeffizienten $v_j$, $w_j$, beispielsweise eines vorangegangenen Zeitschritts, oder durch rekursiv bestimmte Koeffizienten berechnen. Die Feldbestimmungseinrichtung kann hierzu eine Rotationseinheit (oder Curleinheit) zur Bestimmung der Rotation der Felder im Inneren der Gitterzellen sowie eine Traceeinheit zur Bestimmung der Randfelder jeder Gitterzelle umfassen.

Somit dient die erfindungsgemäße Vorrichtung zur Ausführung eines vorgenannten Verfahrens und umfasst Einrichtungen, die dazu dienen, die entsprechenden Verfahrensschritte durchzuführen. Die Vorrichtung ist so ausgelegt, dass die Bestimmungskomplexität, d.h. der Rechenaufwand und der Speicherbedarf, für die Bestimmung der räumlichen und/oder zeitlichen Ableitungen der Nahfeldkomponenten im wesentlichen linear mit der Anzahl N der Partitionen und Anzahl $M$ der Ansatzfunktionen ansteigt, so dass zur Erhöhung der Rechengenauigkeit oder zur Vergrößerung des Rechengebiets bzw. der Darstellung komplexer Systeme unabhängig von der Anzahl M der Ansatzfunktionen ($p$-Verfeinerung) ein in der Anzahl $N$ der Partitionen ($h$-Verfeinerung) linearer Mehraufwand aufgewendet werden muss (und umgekehrt).

Gemäß einer weiteren Ausführungsform der Vorrichtung ist die Partitionierungseinrichtung eingerichtet, ein unstrukturiertes $N$-teiliges Gitter, insbesondere ein Tetraedergitter, ein Prismengitter oder ein gemischtes Gitter unter anderem auch mit Hexaederzellen zur $N$-teiligen Partitionierung der Betrachtungsdomäne zu erzeugen, und eine Randbedingungseinrichtung eingerichtet, elektrische, magnetische oder offene Randbedingungen der Betrachtungsdomäne zu definieren. Die Partitionierungseinrichtung, die auch als Gittergenerator bezeichnet werden kann, ist eingerichtet, ein strukturiertes, ein unstrukturiertes Gitter oder ein hieraus gemischtes Gitter zu erstellen. Solche Partitionierungseinrichtungen sind aus dem Stand der Technik bekannt und dienen zur Generierung eines tetraederförmigen, prismenförmigen Gitters oder eines gemischten Gitters unter anderem auch mit Hexaederzellen, das in der Lage ist, Materialstrukturen elektromagnetischer Systeme mit möglichst geringem Volumen und Oberflächenfehlern nachzubilden. Des Weiteren umfasst die Vorrichtung vorteilhafterweise eine Randbedingungseinrichtung, die eingerichtet ist, elektrische und magnetische Randbedingungen der Betrachtungsdomäne zu definieren. Solche Randbedingungen können beispielsweise offene Randbedingungen sein, die ein kontinuierliches Fortschreiten einer elektromagnetischen Welle oder eines elektromagnetischen Feldes außerhalb des Betrachtungsdomänengebietes nachbilden, oder auch perfekt elektrisch leitende oder magnetisch leitende Randbedingungen, bei denen entsprechend elektrische und/oder magnetische Felder senkrecht auf den Rändern der Betrachtungsdomäne stehen. Die Randbedingungseinrichtung dient dazu, Randbedingungen zur Lösung des elektromagnetischen Feldproblems vorzugeben, so dass im Inneren des Rechengebietes realistische Vorgaben zur Bestimmung der elektromagnetischen Feldkomponenten definiert sind.

Gemäß einer vorteilhaften Weiterentwicklung der Vorrichtung ist die Feldbestimmungseinrichtung eingerichtet, zumindest eine, insbesondere alle elektromagnetischen Nahfeldkomponenten mittels eines DG-FEM-Verfahrens (Discontinous Galerkin Finite Element Method) zu bestimmen. Ein DG-FEM-Verfahren zur Berechnung elektromagnetischer Felder unter Verwendung von orthogonalen Ansatzfunktionen, deren Gewichtungskoeffizienten sich linear rekursiv aus vorbestimmten Gewichtungskoeffizienten bestimmen lassen, erlaubt eine effiziente Bestimmung elektromagnetischer Felder mit im wesentlichen linearer Komplexität der Anzahl $N$ der Partitionen und unabhängig davon im wesentlichen linearer Komplexität bezüglich der Anzahl $M$ verwendeter Ansatzfunktionen $P_i$.

Gemäß eines weiteren vorteilhaften Ausführungsbeispiels umfasst die Feldbestimmungseinrichtung eine Zeitintegrationseinheit, die eingerichtet ist, eine zeitliche Integration der Nahfeldkomponente zumindest einer, insbesondere aller Partitionen bevorzugt mittels eines Leapfrog- oder Runge-Kutta-Zeitschrittverfahrens durchzuführen. Alternativ hierzu kann die Feldbestimmungseinrichtung eine Frequenzbestimmungseinheit umfassen, die eingerichtet ist, eine Berechnung im Frequenzbereich unter Betrachtung einer einzigen oder weniger einzelner Frequenzen durchzuführen, um harmonische Anregungsanalysen einer elektromagnetischen Feldkomponente durchzuführen.

Gemäß einer weiteren vorteilhaften Ausgestaltung der Vorrichtung sind die Komponentenbestimmungseinheit und die Ableitungsbestimmungseinheit eingerichtet, die Koeffizienten $w_i$ linear rekursiv aus einer Menge zuvor bestimmter Koeffizienten $v_j, w_j$ zu bestimmen. Somit umfassen vorteilhafterweise die Komponenten/Ableitungsbestimmungseinheiten einen oder mehrere Datenspeicher zur Speicherung vorausberechneter oder zuvor bestimmter Feld- und Ableitungskoeffizienten $v_j, w_j$, und umfassen weiterhin Rekursionseinheiten, um Koeffizienten linear rekursiv aus vorbestimmten Koeffizienten berechnen zu können.

Gemäß einem weiteren vorteilhaften Ausführungsbeispiel sind die Komponentenbestimmungseinheit und die Ableitungsbestimmungseinheit eingerichtet, die Ansatzfunktion $P_i$ als orthogonale Polynome, insbesondere als Legendre-Polynome und/oder Jacobi-Polynome, zu ermitteln. Hierzu können die vorgenannten Einheiten Polynom-Erzeugungsmittel umfassen, die geeignet sind, orthogonale Polynome beliebiger Ordnung insbesondere rekursiv zu bestimmen und somit Ansatzfunktionen beliebiger Genauigkeit zu erzeugen.

In einem weiteren nebengeordneten Aspekt betrifft die Erfindung ein Computerprogrammprodukt zur Bestimmung eines elektromagnetischen Nahfeldes einer Feldanregungsquelle eines elektrischen Systems, wobei das Computerprogrammprodukt Computerprogrammanweisungen auf einem computerlesbaren Programmspeichermedium, insbesondere Festplatte, CD-ROM, Diskette, Flash-Speicher oder Ähnliches umfasst, und die Computerprogrammanweisungen zumindest einen Computer zur Ausführung eines Verfahrens nach einem der vorgenannten Verfahrensansprüche veranlassen, wenn die Anweisungen von dem Computer gelesen und ausgeführt werden. Somit betrifft dieser Aspekt der Erfindung ein computerlesbares Medium, auf dem Computeranweisungen gespeichert sind, das ablaufend auf einem Rechner ein Verfahren zur Bestimmung eines elektromagnetischen Nahfeldes eines elektrischen Systems bestimmen kann, um das System zu analysieren und/oder zu optimieren. Somit betrifft die Erfindung neben einem Verfahren und einer Vorrichtung auch ein gegenständliches Computerspeichermedium, sowie computerimplementierte Instruktionsvorschriften zur Ausführung einer Analyse und einer Optimierung eines elektromagnetischen Feldproblems innerhalb eines elektrischen Systems, um dieses System zu analysieren, und durch Variation mechanischer oder elektromagnetischer Eigenschaften des Systems hinsichtlich einer gezielten Zielgröße, beispielsweise gewünschte Abstrahlungseigenschaft, geringe Reflexions- und hohe Transmissionseigenschaft, Verringerung eines RCS-Wertes oder Ähnliches zu optimieren.

## BEVORZUGTE AUSFFÜHRUNGSFORMEN

Im nachfolgenden wird ein detailliertes Ausführungsbeispiel des Verfahrens vorgestellt, dass auf einer schnellen Anwendung von Operatoren in einer diskontinuierlichen Galerkin-Formulierung für die Maxwellschen-Gleichungen zur Berechnung elektromagnetischer Komponenten beruht.

### Generelle Beschreibung des Verfahrens

Das folgend beschriebene Verfahren ermöglicht die schnelle Bestimmungssimulation von Antennen, Filtern, elektromagnetischen Kopplern, Wellenleitern und Schaltungen, sowie Streuproblemen durch räumliche Diskretisierung der Maxwell-Gleichungen auf dreidimensionalen unstrukturierten Gittern bestehend aus Tetraedern, Prismen und Hexaedern. Zur zeitlichen Diskretisierung können übliche Verfahren wie Leapfrog- oder Runge-Kutta genutzt werden. Die räumliche Diskretisierung basiert auf einer Formulierung als unstetige Galerkin-Methode (discontinuous Galerkin method). Den Kern der Implementierung bilden Verfahren zur speicheroptimierten und schnellen Anwendung der involvierten Operatoren (Gradient, Trace und deren Transponierten sowie den Massenoperatoren und deren Inversen).

Beschreibung der eingesetzten Formulierung

Bei der räumlichen Diskretisierung der Maxwell-Gleichungen werden unstetige Galerkin-Formulierungen eingesetzt, wie z.B. die unstetige Galerkin-Formulierung mit zentralen Flüssen (central flux) aus [3], die im Folgenden inklusive elektrischer und magnetischer Verluste dargestellt ist:

Es bezeichnen $D^k, k \in [1, K_3]$ die Elemente des Gitters (z.B. Tetraeder). Die unstetigen Ansatz- und Testräume der Ordnung $p$ seien durch $\vec{V}_h^p(D^k)$ bezeichnet. Gesucht seien $\vec{E}_h, \vec{H}_h \in \oplus_k \vec{V}_h^p(D^k)$, so dass für alle $\varphi_h \in \oplus_k \vec{V}_h^p(D^k)$ für alle Elemente $D^k$ gilt:

$$\frac{d}{dt}(\varepsilon_r \vec{E}_h, \varphi_h)_{D^k} = -(\kappa_e \vec{E}_h, \varphi_h)_{D^k} + (c\tilde{u}rl_N \vec{H}_h, \varphi_h)_{D^k}^Z, \tag{1}$$

$$\frac{d}{dt}(\mu_r \vec{H}_h, \varphi_h)_{D^k} = -(\kappa_m \vec{H}_h, \varphi_h)_{D^k} - (c\tilde{u}rl_D \vec{E}_h, \varphi_h)_{D^k}^Y, \tag{2}$$

Hierbei wurden folgende Abkürzungen benutzt (gültig für perfekt elektrisch leitende Randbedingungen):

$$(c\tilde{u}rl_N \vec{H}_h, \varphi_h)_{D^k}^Z = (curl\ \vec{H}_h, \varphi_h)_{D^k} - \frac{1}{2}\sum_{k=1}^{K}\left(\frac{Z^+}{\overline{Z}}\vec{n}\times[\vec{H}_h], \varphi_h\right)_{\partial D^k \setminus \partial\Omega} \tag{3}$$

$$(c\tilde{u}rl_D \vec{E}_h, \varphi_h)_{D^k}^Y = (curl\ \vec{E}_h, \varphi_h)_{D^k} - \frac{1}{2}\sum_{k=1}^{K}\left[\left(\frac{Y^+}{\overline{Y}}\vec{n}\times[\vec{E}_h], \varphi_h\right)_{\partial D^k \setminus \partial\Omega} - \left(\vec{n}\times[\vec{E}_h], \varphi_h\right)_{\partial D^k \cup \partial\Omega}\right] \tag{4}$$

Es lassen sich anisotrope, variable und feldabhängige Materialien nutzen und die Formulierung lässt sich auch für dispersive Materialien, vielfältige Anregungen und komplexere Randbedingungen erweitern. Die Formulierung weist folgende besondere Merkmale auf:

- Mit geeignet gewähltem Zeitintegrator ergibt sich ein explizites, bedingt stabiles Verfahren (z.B. mit einem symplektischen Euler-Zeitintegrator).
- Das Verfahren besitzt keine künstliche Dämpfung, d.h. die Formulierung ist energieerhaltend für verlustfreie Maxwell-Gleichungen.
- Die Formulierung kann so erweitert werden, dass sie keine künstlichen Eigenwerte (spurious modes) aufweist.

In der unstetigen Galerkin-Formulierung müssen unter anderem Terme folgender Art ausgewertet bzw. angewandt werden:

$$(\kappa_e \vec{E}_h, \varphi_h)_{D^k} \qquad \text{(Massenoperator in 3D)} \tag{5}$$

$$(curl\ \vec{H}_h, \varphi_h)_{D^k} \qquad \text{(Curl-Operator in 3D)} \tag{6}$$

$$(\vec{n}\times\vec{H}_h, \varphi_h)_{\partial D^k} \qquad (\text{Trace-Operator 3D->3D}) \qquad (7)$$

Die speicher- und laufzeitoptimierte schnelle Anwendung dieser Operatoren wird im Folgenden beschrieben.

### Schnelle Anwendung der Operatoren

Das Verfahren erreicht durch eine implizite und schnelle Anwendung der involvierten Operatoren (Gradient, Trace und deren Transponierte sowie den Massenoperatoren und deren Inverse) besondere Effizienz bezüglich Speicherbedarf und Rechenzeit auf Hexaeder-, Prismen- und Tetraederelementen. Dies stellt den zentralen Bestandteil der Methode dar. Für jedes Gitterelement werden nur Hilfsgrößen gespeichert und die Operatoren müssen nicht als Matrizen explizit aufgestellt werden. Dies ermöglicht die Reduktion der Komplexität des Speicherbedarfs. Durch Einsatz von hierarchischen orthogonalen Ansatzfunktionen (Legendre- bzw. Jacobi-Polynomen) mit Tensorstruktur (z.B. Dubinerbasis auf den Tetraedern [2]) und kovarianter Transformation auf Referenzelemente wird die Komplexität der Laufzeit der Methode reduziert. Im dreidimensionalen Fall besitzen Speicherbedarf und Laufzeit des Algorithmus die Komplexität $O(p^3)$ für nicht gekrümmte Elemente mit zellweise konstanten und feldunabhängigen Materialkoeffizienten und $O(p^4)$ für gekrümmte Elemente und/oder variable und/oder feldabhängige Materialkoeffizienten (d.h. nicht-lineare Materialgesetze). Hierbei bezeichnet $p$ den Polynomgrad des Verfahrens. Absolute Laufzeiten und Speicherbedarf sind in den Beispielrechnungen weiter unten aufgeführt.

Weitere Merkmale des Verfahrens sind:

- Es stehen Tetraeder-, Prismen- und Hexaeder -Elemente mit beliebig hohem Polynomgrad der Methode zur Verfügung. Es können konforme Gitter mit gemischten Elementtypen eingesetzt werden; bei dem Einsatz von Prismenelementen werden jedoch Gitter mit kompatibler Nummerierung vorausgesetzt;
- Es können in den einzelnen Elementen eines Gitters Ansatzfunktionsräume unterschiedlicher Polynomgrade eingesetzt werden;
- Es stehen gekrümmte Elemente zur Verfügung;
- Es können zellweise konstante, variable sowie feldabhängige Materialkoeffizienten eingesetzt werden und die Materialkoeffizienten können Tensorform haben.

### Schnelle Anwendung der Massenoperatoren

In diesem Verfahren müssen Massenoperatoren (wie in der Gleichung (7) angegeben) und deren Inverse beispielsweise der Umwandlung eines Feldstärkein einen Flussdichtevektor (und umgekehrt) angewandt werden. Durch den Einsatz von Transformationen auf ein vordefiniertes Referenzelement sind die Massenoperatoren abhängig von der Geometrie der einzelnen Elemente. Für ebene Elemente, d.h. Elemente mit konstanter Jacobi-Matrix der Transformation, mit zellweise konstanten und linearen Materialkoeffizienten ergeben sich aufgrund der Orthogonalität der Ansatzfunktionen jedoch 3x3 Block-diagonale Matrizen mit einer Komplexität des Speicheraufwandes und der Anwendung der Operatoren und deren Inversen von $O(p^3)$ für Gleichung (7).

Für allgemeine Elemente (gekrümmte Elemente bzw. Elemente mit variablen und/oder feldabhängigen Materialkoeffizienten) ergibt sich durch Ausnutzung der Tensorstruktur der Ansatzfunktionen in einer sogenannten Summenfaktorisierung [4, S. 179ff] eine schnelle Anwendung mit der Komplexität $O(p^4)$ bzw. $O(p^3)$ in der Laufzeit für den dreidimensionalen bzw. zweidimensionalen Fall. Für eine schnelle Anwendung der Inversen bei variablen und/oder feldabhängigen Materialkoeffizienten kann der Operator aus Gleichung (7) geeignet approximiert werden, um eine entsprechende Komplexität zu erhalten.

Die variablen Transformationskoeffizienten für gekrümmte Elemente können äquivalent approximiert werden, wodurch sich wieder eine Komplexität $O(p^4)$ bzw. $O(p^3)$ für die Anwendung und den Speicheraufwand der Inversen für den 3-dimensionalen bzw. 2-dimensionalen Fall ergibt.

### Schnelle Anwendung der Curl- und Trace-Operatoren und ihrer Transponierten

Durch die Curl- und Trace-Operatoren werden die räumlichen Ableitungen der Maxwellschen Gleichungen in der Diskontinuierlichen Galerkin Methode realisiert. Die Curl-Operatoren wirken dabei auf die Feldgrößen innerhalb der Gitterzellen und die Trace-Operatoren stellen die Feldgrößen auf den Rändern der Gitterzellen zur Verfügung, um numerische Flüsse zwischen den Gitterzellen zu realisieren.

Die Geometrieunabhängigkeit der Curl- und Trace-Operatoren wird durch Einsatz einer kovarianten Transformation der Ansatz- und Testfunktionen jeglicher Elemente von den Funktionsräumen der Referenzelemente, wie z.B.

in [1, S. 331ff] beschrieben, erreicht. Folgend wird der Kern des Verfahrens, die schnelle Anwendung der Curl- und Trace-Operatoren und ihrer Transponierten für die Gitterelemente, beschrieben. Es wurden Rekursionsformeln für hierarchische orthogonale Jacobi-Polynome entwickelt und eingesetzt, die die Komplexität des Speicheraufwandes und der Anwendung des Curl- und Trace-Operators und deren Transponierter auf $O(p^3)$ reduzieren.

Curl-Operator

Die Anwendung des Curl-Operators in Gleichung (6) lässt sich in zwei Teilprobleme aufteilen: Erstens wird die Rotation (curl) der dreidimensionalen Ansatz- bzw. Testfunktionen berechnet. Zweitens wird die entsprechende dreidimensionale Integration gegen Test- bzw. Ansatzfunktionen durchgeführt, die aufgrund der Orthogonalität der Funktionen auf dem Referenzelement, und aufgrund der kovarianten Transformation auch für gekrümmte Elemente, eine triviale Skalierung ist. Das Prinzip der Rekursionsformeln für die Anwendung des Curl-Operators wird im Folgenden anhand des eindimensionalen Gradienten für Legendre-Polynome $P_i(x)$ erläutert: Die Aufgabe besteht darin, bei gegebener Funktion $v(x)$ als Linearkombination von Legendre-Polynomen

$$v(x) = \sum_{i=0}^{M-1} v_i P_i(x) , \qquad\qquad (8)$$

deren Ableitung als Linearkombination von Legendre-Polynomen

$$\mathrm{grad}[v(x)] = \sum_{i=0}^{M-1} v_i \mathrm{grad}[P_i(x)] = \sum_{i=0}^{M-1} w_i P_i(x) , \qquad\qquad (9)$$

d.h. die Koeffizienten $w_i$ zu bestimmen. Durch folgende Beziehung der Legendre-Polynome

$$\mathrm{grad}[P_{i+1}] = \mathrm{grad}[P_{i-1}] + (2i+1)P_i \qquad\qquad (10)$$

ergibt sich

$$\mathrm{grad}[v(x)] = \sum_{i=0}^{M-1} v_i \mathrm{grad}[P_i{}'(x)] = \sum_{i=0}^{M-2} v_i \mathrm{grad}[P_i(x)] + v_{M-1}\mathrm{grad}[P_{M-1}(x)]$$

$$= \sum_{i=0}^{M-2} v_i \mathrm{grad}[P_i(x)] + v_{M-1}\mathrm{grad}[P_{M-3}(x)] + v_{M-1}(2M-3)P_{M-2}(x)$$

$$= \sum_{i=0}^{M-2} \tilde{v}_i \mathrm{grad}[P_i(x)] + v_{M-1}(2M-3)P_{M-2}(x) \qquad\qquad (11)$$

Damit wurde der Koeffizient $w_{n-1}$ berechnet:

$$w_{M-2} = v_{n-1}(2M-3) . \qquad\qquad (12)$$

Durch weitere Anwendung dieses Prinzips lassen sich rekursiv alle Koeffizienten $w_i$ des Gradienten bestimmen, folgend in Pseudocode dargestellt:
for $i = M - 2$ downto 0

$$w_i = (2i+1)v_{i+1} \qquad\qquad . \qquad\qquad (13)$$

if $(i > 0)$ then $v_{i-1} := v_{i-1} + v_{i+1}$
Die Komplexität dieser Anwendung beträgt $O(p)$, d.h. es besitzt eine lineare Komplexität in p und damit auch in der Anzahl der Unbekannten pro Gitterzelle.

Im Dreidimensionalen können für Hexaeder, Prismen und Tetraeder mit geeignet gewählten Ansatzfunktionen basierend auf hierarchischen Jacobi-Polynomen entsprechende rekursive Anwendungsvorschriften erarbeitet werden. Hierzu ergibt sich aufgrund der höheren räumlichen Dimension eine Komplexität der Anwendung von $O(p^3)$. Äquivalent kann die Transponierte dieses Operators berechnet werden.

Zum Auffinden dieser Rekursionsformeln können Verfahren zur Bestimmung multivariater holonomer Funktionen in algorithmischer Weise herangezogen werden, wie sie bereits von D. Zeilberger [7] propagiert wurden, und nach [6] entwickelt wurden. Eine wesentliche Eigenschaft holonomer Funktionen besteht darin, dass sie mittels linearer Rekurrenzen bzw. Differentialgleichungen und den entsprechenden Anfangswerten definiert werden können. Die Klasse der holonomen Funktionen ist abgeschlossen bezüglich der Addition, der Multiplikation und bestimmter Substitutionen. Die in dieser Erfindung verwendeten Basisfunktionen lassen sich problemlos in die Klasse der holonomen Funktionen einordnen. Ein erster Schritt beim Umgang mit holonomen Funktionen ist es, aus dem gegebenen Funktionsausdruck,

z.B. $f(i,j,x,y) = P_j^{(2i+1,0)}(\frac{2y}{1-x}-1)$, die linearen Rekurrenzen und

Differentialgleichungen, denen $f$ genügt, zu berechnen, wobei auch gemischte Differenzen-Differentialgleichungen zulässig sind (die Algorithmen zur Berechnung der holonomen Abschlusseigenschaften wurden von F. Chyzak [5] in seiner Dissertation eingeführt). Alle diese Relationen bilden ein Linksideal in einer Operatoralgebra; dabei handelt es sich um bestimmte Schiefpolynomringe (Ore-Algebren). Das Problem ist nun, ein Element von einer bestimmten Form in diesem Linksideal zu finden. Im vorliegenden Fall soll eine Ableitung der Basisfunktion $f$, z.B. die Ableitung nach der Variablen $x$, durch die Funktion $f$ ausgedrückt werden, wobei die Indizes $i$, $j$ und $k$ geshifted werden dürfen. In der gesuchten Relation darf also nur die erste Ableitung nach $x$ vorkommen, keine höheren $x$-Ableitungen und keine Ableitungen nach $y$ oder $z$. Ferner sollen die Koeffizienten frei von $x$, $y$ und $z$ sein. Nachdem man eine Gröbnerbasis des Linksideals berechnet hat, kann man mittels eines Ansatzes die gewünschte Relation berechnen.

Trace-Operator

Die Anwendung des Trace-Operators aus Gleichung (7) lässt sich ebenfalls in zwei Teilprobleme aufteilen: Erstens werden die Randwerte der dreidimensionalen Ansatz- und Testfunktionen durch die zweidimensionalen Ansatz- und Testfunktionen dargestellt bzw. umgekehrt. Zweitens wird der entsprechende zweidimensionale Skalierung angewendet, die aufgrund der kovarianten Transformation auch für gekrümmte Elemente trivial ist. Die Berechnung der Randwerte entspricht folgendem Problem:

Gegeben sei eine Funktion $v(x)$ auf einem Element $D^k$ (z.B. Tetraeder) durch die Linearkombination der Ansatzfunktionen $P_i(x) \in \vec{V}_h^p(D^k)$:

$$v(x) = \sum_{i=0}^{M_E-1} v_i P_i(x) \qquad \forall x \in D^k . \qquad (1)$$

Gesucht ist nun eine Darstellung des Trace (d.h. der Randwerte) der Funktion $v(x)$ als Linearkombination der Ansatzfunktionen $\psi_i(x) \in \vec{W}_h^p(F^k)$ auf einem Randelement $F^k$ (z.B. Dreieck):

$$\mathrm{tr}_{F^k} v(x) = \sum_{i=0}^{M_R-1} \tilde{w}_i \psi_i(x) \qquad \forall x \in F^k . \qquad (2)$$

Dies kann wiederum für die gewählten Ansatzfunktionen basierend auf hierarchischen Jacobi- Polynomen durch eine Rekursionsformel mit der Komplexität $O(p^3)$ berechnet werden. Äquivalent kann die Transponierte dieses Operators berechnet werden. Zur Auffindung dieser Rekursionsformeln können wiederum wie oben beschrieben Verfahren zur Bestimmung multivariater holonomer Funktionen in algorithmischer Weise herangezogen werden.

Beispielrechnungen

Das obig beschriebene Verfahren wurde in C++ implementiert. Folgend sind die Rechenzeiten pro Unbekannte des Verfahrens für ein 64-bit System mit einer Intel Xeon CPU 5160 3.00 GHz abhängig von der Polynomordnung p für ein Tetraedergitter mit 2078 Elementen in einer beliebig gewählten Einheit zeitlicher Dimension normiert auf Ordnung $p$=1 aufgelistet:

Tabelle 1: Rechenzeit für ungekrümmte Tetraeder-Elemente. Theoretische Abhängigkeit ist $O(1)$.

| Ordnung $p$ | Rechenzeit [bel. Einheit] |
| --- | --- |
| 1 | 1,0 |
| 2 | 1,0 |
| 3 | 1,2 |
| 4 | 1,3 |
| 5 | 1,9 |
| 6 | 2,1 |
| 7 | 2,2 |
| 8 | 2,6 |
| 9 | 2,8 |
| 10 | 2,9 |

Tabelle 2: Rechenzeit für gekrümmte Tetraeder-Elemente. Theoretische Abhängigkeit ist $O(p)$.

| Ordnung $p$ | Rechenzeit [$\mu$sec] |
| --- | --- |
| 1 | 1,0 |
| 2 | 0,51 |
| 3 | 0,39 |
| 4 | 0,37 |
| 5 | 0,41 |
| 6 | 0,44 |
| 7 | 0,48 |
| 8 | 0,55 |
| 9 | 0,59 |
| 10 | 0,62 |

Die Abweichungen von der theoretischen Aufwandskomplexität in $p$ erklären sich mit Laufzeitbeeinflussung des Algorithmus durch unterschiedliche Cache-Effizienzen und unterschiedliche Zusatzkosten durch Funktionenaufrufe. Diese lassen sich weiter optimieren.

Literaturverweis

[1] Gary C. Cohen: "Higher-Order Numerical Methods for Transient Wave Equations. Springer, 2002.

[2] Moshe Dubiner: "Spectral methods on triangles and other domains", Journal of Scientific Computing, 6:345-390, 1991.

[3] Jan S. Hesthaven and Tim Warburton: "Nodal Discontinuous Galerkin Methods - Algorithms, Analysis, and Applications", Springer Science+Business Media, LLC, New York, 2008.

[4] George Em Karniadakis and Spencer Sherwin: "Spectral/hp Element Methods for Computational Fluid Dynamics", Oxford Univ. Press, 2005.

[5] Frederic Chyzak: "Fonctions holonomes en Calcul formel", PhD thesis, Ecole polytechnique, 1998.

[6] Christoph Koutschan: "Advanced Applications of the Holonomic Systems Approach", PhD thesis, RISC-Linz, Johannes Kepler Universität 2009.

[7] Doron Zeilberger: "A holonomic systems approach to special function identities", Journal of Computational and Applied Mathematics, 32(3):321-368, 1990.

ZEICHNUNGEN

Weitere Vorteile ergeben sich aus der vorliegenden Zeichnungsbeschreibung. In der Zeichnung sind Ausführungsbeispiele der Erfindung dargestellt. Die Zeichnung, die Beschreibung und die Ansprüche enthalten zahlreiche Merkmale in Kombination. Der Fachmann wird die Merkmale zweckmäßigerweise auch einzeln betrachten und zu sinnvollen weiteren Kombinationen zusammenfassen.

Es zeigen:

**Fig. 1**      einen schematischen Ablaufplan eines ersten Ausführungsbeispiels des Verfahrens;

**Fig. 2**      schematisch eine Blockdarstellung eines ersten Ausführungsbeispiels einer erfindungsgemäßen Vorrichtung;

**Fig. 3**      Fehlerbetrachtungen bei Anwendung eines Ausführungsbeispiels eines erfindungsgemäßen Verfahrens mit Legendre-Polynomen bis zum Grad 12 zur Bestimmung von Eigenresonanzen eines Rechteckresonators;

**Fig. 4**      eine Konvergenzstudie zur Bestimmung von Eigenmoden eines Kugelresonators unter Verwendung eines Ausführungsbeispiels des erfindungsgemäßen Verfahrens mit Polynomen des Polynomgrads 1 bis 8;

**Fig. 5**      ein Rechteckhohleiters eines elektrischen System eines mit zwei unterschiedlichen Dielektrikafüllungen und einer tetraederförmigen Diskretisierung;

**Fig. 6**      ein Zeitbereichsergebnis einer Impulsreflexion des in **Fig. 5** dargestellten Wellenleiter unter Verwendung eines Ausführungsbeispiels des erfindungsgemäßen Verfahrens;

**Fig. 7**      Der Verlauf eines Betrags und einer Phase der Transmission eines elektrischen Modes durch den in **Fig. 5** dargestellten Wellenleiter unter Anwendung eines erfindungsgemäßen Verfahrens;

**Fig. 8**      verschiedene Partitionszellen eines unstrukturierten Gitters;

**Fig. 9**      eine Darstellung eines elektromagnetischen Systems eines Flugzeuges mit einfallender ebenen Welle;

**Fig. 10**     eine Betrachtungsdomäne des in **Fig. 9** dargestellten elektrischen Systems;

**Fig. 11**     einen Schnitt durch eine tetraederförmige Partition der in **Fig. 10** dargestellten Betrachtungsdomäne;

**Fig. 12**     ein Ergebnis einer Nahfeldanalyse einer einfallenden Welle auf das in **Fig. 9** dargestellte Flugzeug unter Anwendung eines Ausführungsbeispiels des erfindungsgemäßen Verfahrens;

**Fig. 13**     eine zeitliche Entwicklung einer elektromagnetischen Feldkomponente unter Anwendung eines Zeitbereichsverfahrens eines Ausführungsbeispiels.

AUSFÜHRUNGSFORMEN DER ERFINDUNG

In den Figuren sind gleiche oder gleichartige Komponenten mit gleichen Bezugszeichen beziffert.

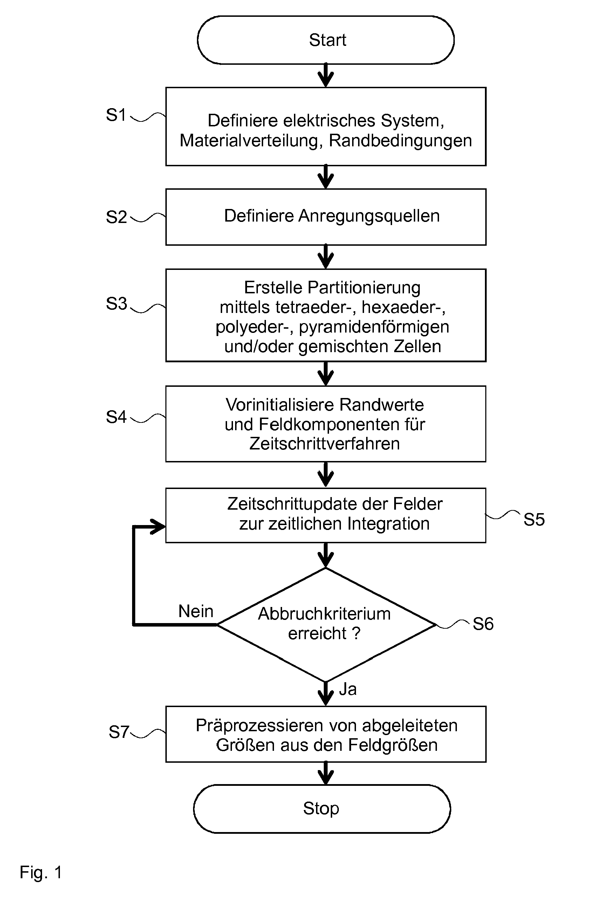

**Fig. 1** stellt einen Ablaufplan einer Ausführungsform des erfindungsgemäßen Verfahrens dar. Hierbei wird in Schritt S1 das elektrische System in einer in $N$-Partitionen aufgeteilten Betrachtungsdomäne definiert, wobei den einzelnen Partitionen (Gitterzellen) Materialverteilungen zugeordnet werden, insbesondere $\varepsilon$- und $\mu$-Verteilungen (elektrische Permittivität und magnetische Permeabilität) sowie geeignete Randbedingungen zur geeigneten Definition des Feldverhaltens an den Rändern der Betrachtungsdomäne festgelegt werden (offene Ränder, perfekt elektrisch leitende Ränder, perfekt magnetisch leitende Ränder, Mischformen etc.).

In Schritt S2 werden Anregungsquellen zur Anregung eines elektromagnetischen Feldes definiert, beispielsweise können dies Dipolanregungen, stromdurchflossene Leiter, Portanregungen, d.h. Einprägen von eingekoppelten Feldmoden, TEM-Wellen oder sonstige elektromagnetische Anregungsquellen sein.

In Schritt S3 erfolgt die Partitionierung der Betrachtungsdomäne durch tetraeder-, hexaeder-, polyeder- oder prismenförmige Zellen, um die N-teilige Partition zu erstellen.

In Schritt S4 werden Randwerte und Feldkomponenten beispielsweise für die Vorbereitung eines Zeitschrittverfahrens initialisiert, woraufhin eine explizite Zeitschrittformulierung mittels Leapfrog- oder Runge-Kutta-Verfahren angewendet werden kann.

In Schritt S5 werden mittels eines Zeitschrittupdates die einzelnen Feldkomponenten mit einem geeigneten Zeitschritt, der sich in der Regel an einem Stabilitätskriterium orientiert, bestimmt, wobei in Schritt S6 ein Abbruchkriterium überprüft wird, beispielsweise das Abklingen einer Feldenergie unter einem vorbestimmbaren Wert, der Ablauf einer gewissen Zeit bzw. einer gewissen Anzahl von Zeitschritten oder Ähnliches. Solange das Abbruchkriterium nicht erreicht wird, wird das Zeitschrittupdate nach Schritt S5 weiter durchgeführt. Nach Beendigung der Zeitschrittschleife werden in Schritt S7 die aufgezeichneten zeitlichen Felder nachbearbeitet (Postprocessing), beispielsweise in den Frequenzbereich mittels einer FFT/DFT transformiert und abgeleitete Größen, beispielsweise Transmissions- und Reflexionsparameter berechnet sowie Visualisierungen der Felder erstellt.

Mittels des aufgeführten Verfahrens und unter Verwendung von orthogonalen Ansatzfunktionen, deren zeitliche und/oder räumliche Ableitungen sich ebenfalls aus den Linearpositionen dieser Ansatzfunktionen ergeben, kann ein Berechnungsverfahren linearer Komplexität vorgeschlagen werden, dessen zeitlicher und speichertechnischer Aufwand im wesentlichen linear mit der Anzahl der eingesetzten Partitionen $N$ und der Zahl $M$ der Ansatzfunktionen $P_i$ pro Feldkomponente wächst.

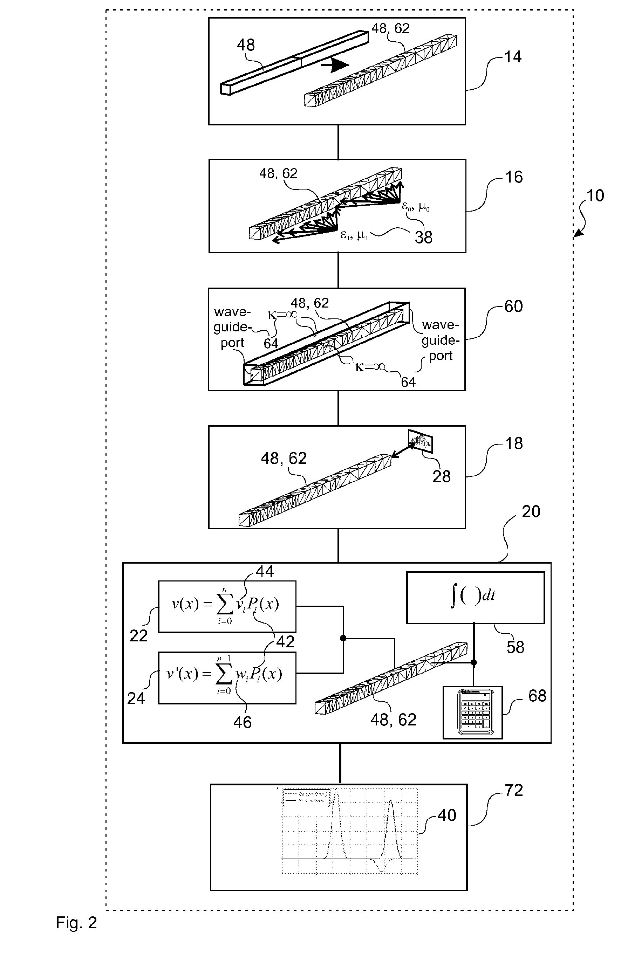

**Fig. 2** stellt in einem Blockschaubild ein Ausführungsbeispiel 10 einer Vorrichtung zur Bestimmung des Nahfeldes eines elektrischen Systems dar, wobei die Feldberechnungsvorrichtung 10 eine Partitionierungseinrichtung 14 zur Partitionierung eines elektrischen Systems in einzelne Gitterzellen, eine Materialverteilungseinrichtung 16 zur Zuordnung einer Materialverteilung in die einzelnen Gitterzellen, eine Randbedingungseinrichtung 60 zur Definition von Randbedingungen, eine Quelleneinrichtung 18 zur Definition einer Feldanregungsquelle sowie eine Feldbestimmungseinrichtung 20 zur Bestimmung eines elektrischen Feldes und eine Postprocessing-Einrichtung 72 zur Nachbearbeitung abgeleiteter Größen 40 aus den Ergebnissen der Feldberechnung. Die Partitionierungseinrichtung 14 dient in diesem Fall dazu, einen Wellenleiter 48, der zwei verschiedene dielektrische Materialien $\varepsilon_1$, $\varepsilon_2$ umfasst, in eine Betrachtungs-domäne 62 zu überführen, und den Wellenleiter 48 in einzelne tetraederförmige Gitterzellen zu diskretisieren. In der nachgeschalteten Materialverteilungseinrichtung 16 werden den einzelnen tetraederförmigen Gitterzellen elektrische und magnetische Permeabilitäts- und Permitivitätswerte $\mu$, $\varepsilon$ zugewiesen und in der Randbedingungseinrichtung 60 die längs erstreckten Ränder des Wellenleiters 48 als perfekt elektrisch leitende Ränder definiert, sowie die in Längsrichtung abschließenden Ränder als sogenannte "Waveguide-Ports" zum Einkoppeln und Auskoppeln von Wellenleitermoden definiert. Diese Randbedingungen 64 definieren das Verhalten der elektromagnetischen Felder am Rand der Betrachtungsdomäne und ermöglichen im nachfolgenden Berechnungsverfahren die Berücksichtigung der Randbedingungen zur Bestimmung der Feldausbreitung. Die Quelleneinrichtung 18 definiert eine elektromagnetische Feldanregungsquelle 28, die in diesem Fall als Einkoppeln eines Wellenleitermodes an einem Längsrand des Wellenleiters 48 des diskretisierten Models 62 erfolgt. Die Feldbestimmungseinrichtung umfasst eine Komponentenbestimmungseinheit 22 zur Generierung einer Linearposition bezüglich des L2-Skalarproduktes orthogonaler vorbestimmter Ansatzfunktionen $P_i$ 42, die mit Feldkoeffizienten $v_i$ 44 gewichtet die Feldverläufe jeder Feldkomponente charakterisieren. Des Weiteren umfasst die Feldbestimmungseinrichtung 20 eine Ableitungsbestimmungseinheit 24, die die Ableitung der das Feld beschreibenden Linearposition von orthogonalen Ansatzfunktionen bestimmen kann, die sich wiederum als Linearposition von dieser Ansatzfunktion $P_i$ 42 gewichtet mit Ableitungskoeffizienten $w_i$ 46 ergibt. Die Ermittlung der Fehlkoeffizienten $v_i$ 44 und Ableitungskoeffizienten $w_i$ 46 kann linear rekursiv, beispielsweise durch eine Bestimmungssteuereinheit 68 erfolgen.

Des Weiteren umfasst die Feldbestimmungseinrichtung 20 eine Zeitintegrationseinheit 58, die ein Leapfrog-Schema oder ein Runge-Kutta-Zeitschrittschema zur zeitlichen Integration der Maxwellschen-Gleichungen für die transiente Analyse der Nahfeldentwicklung der Betrachtungsdomäne durchführt. Nach Ablauf der Zeitintegration, beispielsweise nach Abklingen des elektromagnetischen Feldes innerhalb der Betrachtungsdomäne, werden die aufgezeichneten Felder oder ein- und ausgekoppelten Felder aus dem Rechengebiet mittels einer Postprocessing-Einheit 72 ausgewertet, dabei können beispielsweise Reflexions- und Transmissionskoeffizienten S11, S12, S22, S21 eines Wellenleiterübergangs bestimmt werden.

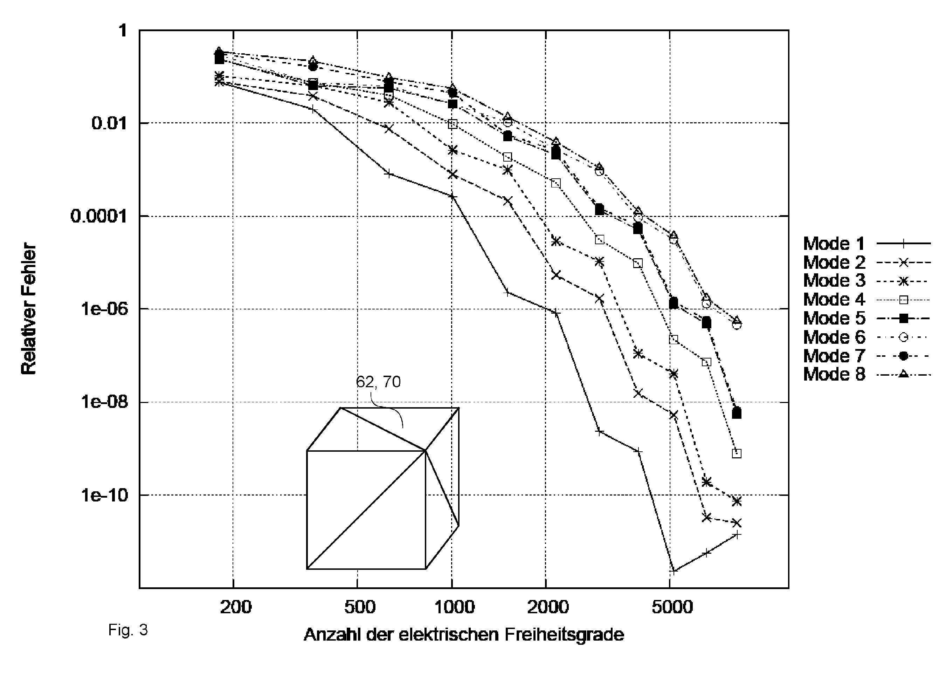

**Fig. 3** zeigt eine Beispielrechnung von Eigenmoden eines Rechteckresonators 70 mittels eines Ausführungsbeispiels des erfindungsgemäßen Verfahrens. Der Rechteckresonator 70 wurde mit sechs Tetraederelementen diskretisiert und es wurden die ersten acht Resonanzfrequenzen der Eigenmoden des Rechteckresonators 70 bestimmt, wobei der Polynomgrad der Ansatzpolynome von 2 auf 12 erhöht wurde, wodurch sich jeweils genauere Feldberechnungsergebnisse ergaben. Der relative Fehler in den Resonanzfrequenzen gegenüber einer analytischen Lösung ist für die ersten acht Moden in Abhängigkeit vom gewählten Polynomgrad 2 bis 12 dargestellt, wobei der relative Fehler exponentiell konvergiert.

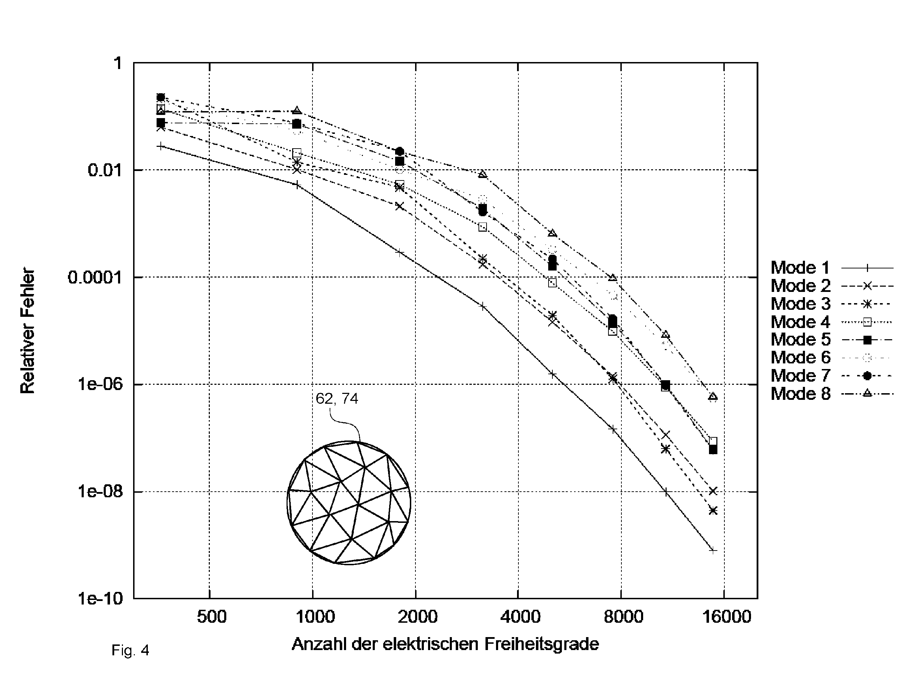

In **Fig. 4** ist in analoger Weise eine Beispielrechnung der Bestimmung der ersten acht Eigenmoden eines Kugelresonators 74, der mittels dreißig gekrümmten Tetraederelementen diskretisiert wurde, aufgezeichnet. Der relative Fehler gegenüber den analytischen Eigenresonanzen der ersten acht Moden ist bei einer Erhöhung des Polynomgrads von 1<=$p$<=8 dargestellt, wobei der Fehler exponentiell konvergiert.

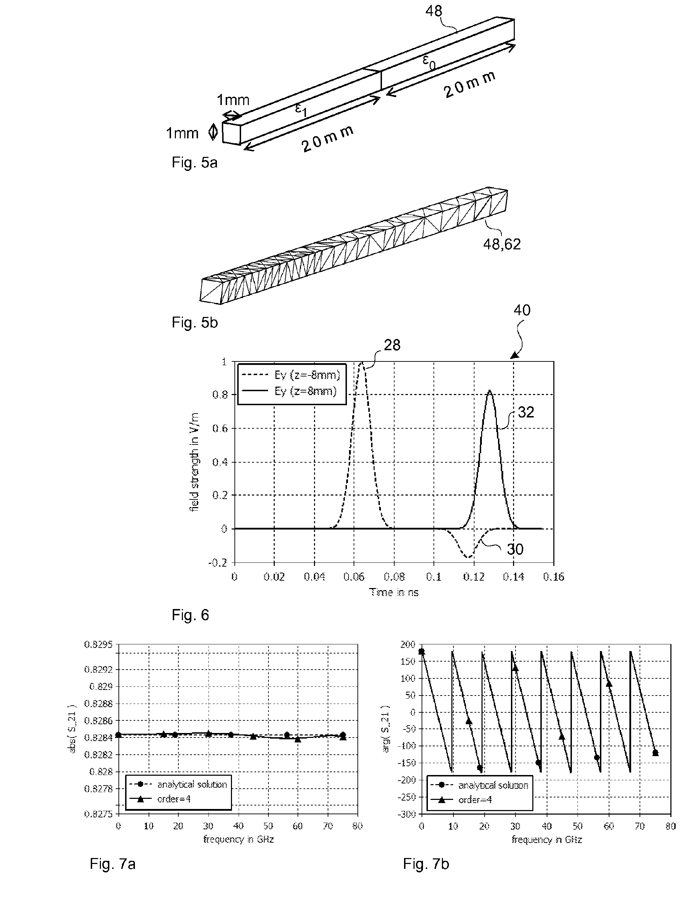

**Fig. 5** zeigt einen Wellenleiter 48, durch den eine ebene TEM-Welle geleitet werden kann. Der Wellenleiter 48 weist Dimensionen von einem auf einen Millimeter Querschnitt sowie 40 mm Länge auf, wobei er streckenweise mit dielektrischem Materialien gefüllt ist, das verschiedene Permittivitäten $\varepsilon_0$, $\varepsilon_1$ aufweist. Der Wellenleiter 48 ist an den beiden Enden mit perfekt elektrisch leitfähigen Materialien abgeschlossen, während die längsseitigen Begrenzungsflächen mit perfekt magnetisch leitenden Randbedingungen abgeschlossen sind. **Fig. 5b** zeigt die Diskretisierung des Wellenleiter 48 mittels 327 Tetraederzellen in der Betrachtungsdomäne 62, wobei die Feldwerte mit Polynomen bis vierten Grades beschrieben werden. Bei der Diskretisierung wird entsprechend dem Verhältnis der Permittivitätswerte der Bereich mit höherem $\varepsilon_1$ feiner diskretisiert als der Bereich mit geringeren $\varepsilon_0$ ist. Zur Simulation wird an einem Längsende des Wellenleiter 48 eine TEM-Welle mit einem gaußförmigen Impuls mit der Mittenfrequenz von 37,5 GHz angeregt.

**Fig. 6** zeigt den zeitlichen Verlauf der Feldanregung 28 gestrichelt als Impuls bei etwa 0,06 ns. Zeitlich versetzt sieht man gestrichelt den reflektierten Impuls an der Übergangsschicht der beiden Dielektrizitätsmaterialien bei ca. 0,12 ns als Signalreflexion 30 sowie kurze Zeit später die auf der gegenüberliegenden Seite austretende Impulsform der Signaltransmission 32. Die zeitlichen Verläufe zeigen die Signalwerte zweier elektromagnetischer Nahfeldkomponenten 40 der elektrischen Feldstärke $E_y$ an Positionen bei z=-8mm und bei z=8mm.

Aus dem Zeitverläufen der elektrischen Nahfeldkomponenten der **Fig. 6** können durch geeignete FFT/DFT-Operationen breitbandige Untersuchungsergebnisse des Transmissionswertes S21 im Frequenzbereich abgeleitet werden. **Fig. 7a** stellt den Betrag |S21| der Signaltransmission 32 breitbandig dar, sowie **Fig. 7b** den Verlauf des Phasenwinkels von S21 bei Verwendung von Ansatzfunktionen bis zur vierten Ordnung unter Verwendung eines Ausführungsbeispiels des erfindungsgemäßen Verfahrens dar.

Das Gitter der **Fig. 5b** wurde mit 327 Tetraederzellen diskretisiert und die Ansatzfunktionen haben eine maximale Ordnung von vier. In **Fig. 7a** und **7b** wurden die simulierten Nahfeldkomponenten mit analytischen Ergebnissen verglichen, wobei keine signifikanten Abweichungen zu erkennen sind.

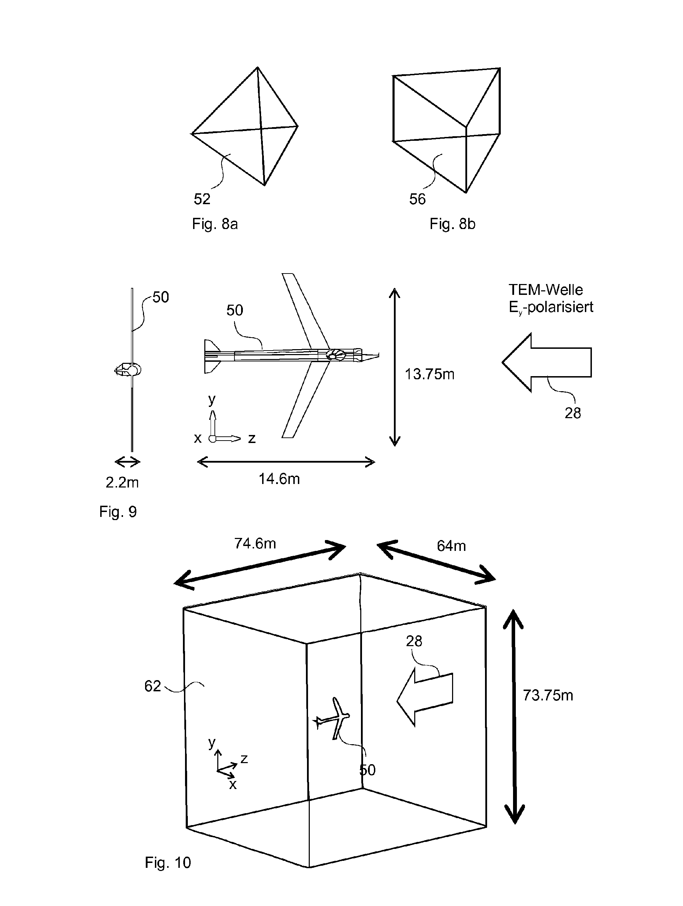

**Fig. 8** zeigt Grundformen verschiedener Gitterzellen (Partitionen), wie sie vorteilhafterweise in Ausführungsbeispielen des erfindungsgemäßen Verfahrens verwendet werden können. Dabei zeigt **Fig. 8a** den Prototyp einer tetraederförmigen Gitterzelle 52, die vier Flächen, sechs Kanten und 4 Knoten aufweist. **Fig. 8b** zeigt eine prismenförmige Gitterzelle 56, die fünf Flächen, neun Kanten, und sechs Knoten aufweist. Auf den Flächen sowie im Volumen der Gitterzellen können Ansatzfunktionen zur Beschreibung der elektromagnetischen Nahfeldkomponente in der Gitterzelle definiert werden.

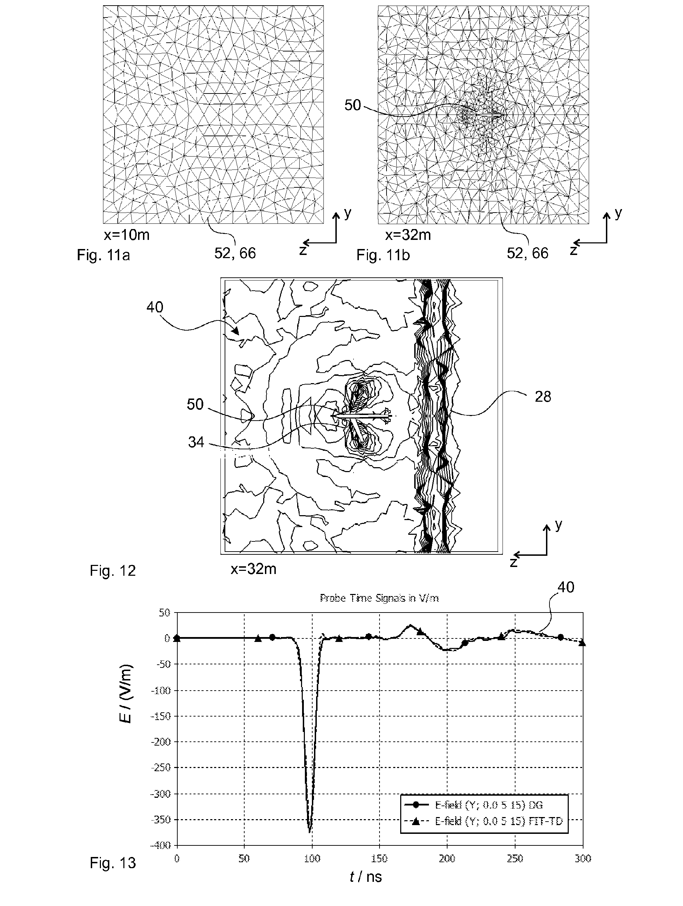

**Fig. 9** zeigt ein Modell eines Flugzeugs 50, auf das eine ebene TEM-Welle fällt, wie sie beispielsweise von einem Radargerät ausgesendet werden kann. Eine Analyse des Streufeldes des Flugzeugs 50 ermöglicht einen Rückschluss auf die RCS (Radar Cross Section) des Flugzeugs, die ein Maß für das reflektierte Radarbild gibt und die beispielsweise im militärischen Bereich zur Entwicklung von Flugzeugformen mit möglichst geringer Radarsichtbarkeit betrachtet wird. **Fig. 9** gibt die Dimensionen des Flugzeugs an, wobei **Fig. 10** eine Berechnungsdomäne 62 darstellt, innerhalb der das Flugzeug 50 betrachtet wird, wobei als Feldanregungsquelle 28 eine $E_y$-polarisierte TEM-Quelle senkrecht auf das Flugzeug auftrifft. Hierzu zeigen **Figs. 11a** und **11b** in zweidimensionalen Schnitten durch die Betrachtungsdomäne 62 die Auflösung des Tetraedergitters, wobei in **Fig. 11a** ein Schnitt innerhalb eines mit Luft gefüllten Bereichs durch die Betrachtungsdomäne 62 dargestellt ist, und in **Fig. 11b** ein Schnitt durch das Flugzeug dargestellt wird, wobei das unstrukturierte Tetraedergitter eine hohe Auflösung der Flugzeugdetails 50 im Inneren des Rechengebiets 62 ermöglicht. Das Flugzeug hat eine Spannweite von 13,75 Metern und eine Länge von 14,6 Metern. Die Höhe beträgt 2,2 Meter. Das Rechengebiet ist quadratisch in eine Dimension von 64m x 73,75m x 74,6 m (BxHxT) aufgeteilt, wobei eine Symmetrieeigenschaft zur Reduzierung des Rechenaufwands ausgenutzt wird. **Fig. 12** zeigt nun in einer Isoplotdarstellung die Verteilung von Absolutwerten elektrischer Feldstärken der elektromagnetischen Nahfeldkomponenten 40 im Rechengebiet zu einem Zeitpunkt von 208ns nach Aussendung der ebenen TEM-Welle 28, wobei sich um das Flugzeug 50 herum ein Streufeld 34 ergibt, aus dem das RCS ausgerechnet werden kann. Deutlich zu erkennen ist die ebene Welle als Feldanregungsquelle 28.

**Fig. 13** stellt den zeitlichen Verlauf eines Punktmonitors einer Nahfeldkomponente 40 an dem Punkt (0.0,5,15) im Vergleich mit einer hoch aufgelösten FI-Zeitbereichsrechnung dar, die nahezu identische Ergebnisse liefert. Somit kann eine Implementation des erfindungsgemäßen Verfahrens mit einem Ergebnis einer bewährten Zeitbereichsrechnung, die ein strukturiertes hexaederbasiertes Gitter verwendet, verglichen werden. Zur Auflösung der Betrachtungsdomäne 62 wurden 18.894 Tetraeder verwendet, wobei der Polynomgrad der verwendeten Polynome bis 6 beträgt. Das Verfahren ermöglicht idealerweise eine lineare Komplexität des Rechenaufwands bezüglich der Anzahl der Partitionen $N$ und der Anzahl der Ansatzfunktionen $M$ bei Verwendung unstrukturierter Gitter, insbesondere tetraederförmiger oder prismenförmiger Gitter, wobei gekrümmte und fein detaillierte Bereiche eines elektrischen Systems extrem gut aufgelöst werden können. Werden gekrümmte Gitterzellen verwendet, liegt der Aufwand allerdings höher. Damit eröffnet das Verfahren die Verwendung einer FEM-Formulierung auf unstrukturierten Gittern mit erhöhter Oberflächen- und Volumenapproximationsgenauigkeit bei einer im Wesentlichen linearen Skalierbarkeit des Bestimmungsaufwands bezüglich N und *M*.

**Patentansprüche**

1. Verfahren unter Verwendung eines entsprechend programmierten Computers oder einer entsprechend eingerichteten Rechnervorrichtung (10) zur Bestimmung eines elektromagnetischen Nahfeldes (26) einer Feldanregungsquelle (28) eines elektrischen Systems (12), insbesondere für die Analyse und/oder Optimierung einer Antennenabstrahlung, eines Übersprechproblems, einer Signalreflexion/- transmission, eines Streufeldes, eines Einstrahlproblems oder dergleichen, innerhalb einer das System (12) umfassenden und in *N*-Partitionen (36) aufgeteilten Betrachtungsdomäne (62), umfassend die Schritte:

   - Definition elektrischer und magnetischer Eigenschaften der Materialverteilung (38) des Systems (12) in jeder Partition (36) innerhalb der Betrachtungsdomäne (62);
   - Definition mindestens einer Feldanregungsquelle (28) innerhalb des Systems (12);
   - Bestimmung der elektromagnetischen Nahfeldkomponenten (40) innerhalb zumindest einer, insbesondere aller Partitionen (36) durch Lösen der Maxwellschen-Gleichungen des Nahfeldes (26) unter Berücksichtung der definierten Materialverteilung (38) und der definierten Feldanregungsquelle (28),
   wobei zur Lösung der Maxwellschen-Gleichungen eine unstetige Galerkin Formulierung (DG-FEM-Formulierung) des Nahfeldproblems eingesetzt wird,
   **dadurch gekennzeichnet, dass** die zur Berechnung der räumlichen und/oder zeitlichen Ableitung erforderlichen Anwendungen von Massenoperation, Curl-Operation und Trace-Operation auf die Nahfeldkomponente (40) einen Bestimmungsaufwand linear zur Anzahl *N* der Partitionen (36) der Betrachtungsdomäne (62) und zur Anzahl *M* der in der Linearposition verwendeten Ansatzfunktionen $P_i$ (42) aufweisen, wobei jede Nahfeldkomponente (40) jeder Partition (36) durch eine Linearposition von *M* vorbestimmten, holonomen und zueinander bezüglich eines Skalarproduktes orthogonalen Ansatzfunktionen $P_i$ (42) gewichtet mit Feldkoeffizienten $v_i$ (44)

   als $v(x) = \sum_{i=0}^{M-1} v_i P_i(x)$ dargestellt wird, eine räumliche Ableitung der Nahfeldkomponente (40) als Linearposition dieser Ansatzfunktionen $P_i$ (42) gewichtet mit Ableitungskoeffizienten $w_i$ (46) als

   $$\mathrm{grad}[v(x)] = \sum_{i=0}^{M-1} v_i \mathrm{grad}[P_i(x)] = \sum_{i=0}^{M-1} w_i P_i(x)$$ dargestellt wird, und jeder Koeffizient $w_i$ (46) rekursiv aus einer Menge von Feldkoeffizienten $v_i$ (44) und zuvor bestimmten Ableitungskoeffizienten $w_j$ (46) durch $w_i = f(v_j, w_j)$ mit linearem Aufwand berechnet wird.

2. Verfahren nach Anspruch 1,
   **dadurch gekennzeichnet, dass** die Partitionen (36) der Berechnungsdomäne durch ein unstrukturiertes Gitter, insbesondere ein tetraederförmiges (52), prismenförmiges (56) oder gemischtes Gitter (66) beschrieben werden.

3. Verfahren nach einem der vorangegangenen Ansprüche, **dadurch gekennzeichnet, dass** die Ansatzfunktionen $P_i$ (42) Legendre-Polynome und/oder Jacobi-Polynome sind.

4. Verfahren nach Anspruch 3,
   **dadurch gekennzeichnet, dass** für eine 1D-Felddarstellung mit Legendre-Polynomen für *i=M*-1 bis 0 sowie $\hat{v}_M = 0$,

   $\hat{v}_{M\text{-}1} = v_{M\text{-}1}$ rekursiv gilt: $w_i = (2i + 1)\hat{v}_{i+1}$ und $\widehat{v}_{i-1} := v_{i-1} + \dfrac{1}{2i+1} w_i$ für alle *i*>0.

5. Verfahren nach einem der vorangegangenen Ansprüche,
   **dadurch gekennzeichnet, dass** zur Bestimmung der elektromagnetischen Nahfeldkomponenten (40) ein explizites und/oder implizites zeitliches Integrationsverfahren, insbesondere ein Leapfrog- oder ein Runge-Kutta Zeitschrittverfahren angewendet wird, wobei ein Abbruchkriterium der zeitlichen Integration die Erreichung einer vorbestimmten Anzahl von Zeitschritten und/oder das Erreichen eines vorbestimmten Energiefeldwertes ist.

6. Rechnervorrichtung (10) eingerichtet für die Ausführung eines Verfahrens nach einem der vorgenannten Verfahrensansprüche, um ein elektromagnetisches Nahfeld (26) einer Feldanregungsquelle (28) eines elektrischen Systems (12) zu bestimmen, insbesondere für die Analyse und/oder Optimierung einer Antennenabstrahlung, eines Übersprechproblems, einer Signalreflexion/-transmission, eines Streufeldes, eines Einstrahlproblems etc., umfassend:

eine Partionierungseinrichtung (14) zur Definition einer $N$-teiligen Partition (36) einer Berechnungsdomäne, die das System (12) beinhaltet, und innerhalb derer das Nahfeld (26) bestimmt werden soll;
eine Materialverteilungseinrichtung (16) zur Definition elektrischer und
magnetischer Eigenschaften der Materialverteilung (38) des Systems (12) in jeder Partition (36) innerhalb der Betrachtungsdomäne (62);
eine Quelleneinrichtung (18) zur Definition mindestens einer Feldanregungsquelle (28) innerhalb des Systems (12);
eine Feldbestimmungseinrichtung (20) zur Bestimmung jeder elektromagnetischen Nahfeldkomponente (40) innerhalb zumindest einer, insbesondere aller Partitionen (36) durch Lösung der Maxwellschen Gleichungen unter Berücksichtigung der bestimmten Materialverteilung (38) und der bestimmten Feldanregungsquelle (28), **dadurch gekennzeichnet, dass** die Feldbestimmungseinrichtung (20) eine Komponentenbestimmungseinheit (22) zur Ermittlung einer Linearposition von $M$ vorbestimmter, holonomer und zueinander bezüglich eines Skalarproduktes orthogonaler Ansatzfunktionen $P_i$ (42) gewichtet mit Feldkoeffizienten $v_i$ (44) für jede Nahfeldkomponente (40) und eine Ableitungsbestimmungseinheit (24) zur Bestimmung der zur Lösung der Maxwellschen-Gleichungen erforderlichen räumlichen und/oder zeitlichen Ableitungen jeder Nahfeldkomponente (40) als Linearposition dieser Ansatzfunktionen $P_i$ (42) gewichtet mit Ableitungskoeffizienten $w_i$ (46) umfasst, wobei die Ableitungsbestimmungseinheit (24) eingerichtet ist, um bei der Bestimmung der räumlichen Ableitung jeder elektrischen Nahfeldkomponente (26) jeden Koeffizienten $w_i$ (46) linear rekursiv aus einer Menge zuvor bestimmter Feldkoeffizienten $v_j$ (44) und Ableitungskoeffizienten $w_j$ (46) zu bestimmen, so dass der Bestimmungsaufwand des Nahfelds (26) des Systems (12) linear zur Anzahl $N$ der Partitionen (36) der Betrachtungsdomäne (62) und zur Anzahl $M$ der in der Linearposition verwendeten Ansatzfunktionen $P_i$ (42) steigt.

7. Vorrichtung nach Anspruch 6, **dadurch gekennzeichnet, dass** die Partionierungseinrichtung (14) eingerichtet ist, ein unstrukturiertes $N$-teiliges Gitter, insbesondere ein Tetraedergitter (52), ein Prismengitter (56) oder ein gemischtes Gitter (66) zur N-teiligen Partionierung (36) der Betrachtungsdomäne (62) zu erstellen, und eine Randbedingungseinrichtung (60) eingerichtet ist, elektrische und magnetische Randbedingungen (64) der Berechnungsdomäne zu definieren.

8. Vorrichtung nach einem der vorangegangenen Vorrichtungsansprüche, **dadurch gekennzeichnet, dass** die Feldbestimmungseinrichtung (20) eingerichtet ist, zumindest eine, insbesondere alle elektromagnetischen Nahfeldkomponenten (40) mittels eines DG-FEM (Discontinuous Galerkin Finite Element Method) Verfahrens zu bestimmen.

9. Vorrichtung nach einem der vorangegangenen Vorrichtungsansprüche, **dadurch gekennzeichnet, dass** die Feldbestimmungseinrichtung (20) eine Zeitintegrationseinheit (58) umfasst, die eingerichtet ist, eine zeitliche Integration der Nahfeldkomponenten (40) zumindest einer, insbesonderer aller Partitionen (36) bevorzugt mittels eines Leapfrog- oder Runge-Kutte Zeitschrittverfahrens durchzuführen.

10. Vorrichtung nach einem der vorangegangenen Vorrichtungsansprüche, **dadurch gekennzeichnet, dass** die Komponentenbestimmungseinheit (22) und die Ableitungsbestimmungseinheit (24) eingerichtet sind, die Ansatzfunktionen $P_i$ (42) als Legendre-Polynome und/oder Jacobi-Polynome zu ermitteln.

11. Computerprogrammprodukt zur Bestimmung eines elektromagnetischen Nahfeldes (26) einer Feldanregungsquelle (28) eines elektrischen Systems (12), wobei das Computerprogrammprodukt Computerprogrammanweisungen auf einem computerlesbaren Programmspeichermedium, insbesondere Festplatte, CD-ROM, Diskette, Flash-Speicher oder Ähnliches umfasst, **dadurch gekennzeichnet, dass** die Computerprogrammanweisungen zumindest einen Computer oder eine Rechnervorrichtung nach einem der Ansprüche 6 bis 10 zur Ausführung eines Verfahren nach einem der vorgenannten Verfahrensansprüche veranlasst, wenn die Anweisungen von dem Computer bzw. der Rechnervorrichtung gelesen und ausgeführt werden.

**Claims**

1. Method using an appropriately programmed computer or an appropriately designed computing device (10) for determining an electromagnetic near-field (26) of a field excitation source (28) of an electrical system (12), in particular for analysis and/or optimization of antenna radiation, of a crosstalk problem, of signal reflection/transmission, of a stray field, of an irradiation problem or the like, inside a domain under consideration (62) comprising the system (12) and split into *N*-partitions (36), comprising the steps:

- defining electric and magnetic properties of the material distribution (38) of the system (12) in each partition (36) inside the domain under consideration (62);
- defining at least one field excitation source (28) inside the system (12);
- determining the electromagnetic near-field components (40) inside at least one and in particular all partitions (36) by solving the Maxwell's equations of the near-field (26), taking into account the defined material distribution (38) and the defined field excitation source (28),

where a discontinuous Galerkin formulation (DG-FEM formulation) of the near-field problem is used to solve the Maxwell's equations, **characterized in that** the applications of mass operator, curl operator and trace operator necessary for computing the spatial and/or time derivative to the near-field component (40) exhibit a determination effort linear to the number $N$ of partitions (36) of the domain under consideration (62) and to the number $M$ of the test functions $P_i$ (42) used in the linear position, where each near-field component (40) of each partition (36) is represented as $v(x) = \sum_{i=0}^{M-1} v_i P_i(x)$ by a linear position of $M$ predetermined and holonomic

test functions $P_i$ (42) orthogonal to one another in respect of a scalar product and weighted with field coefficients $v_i$ (44), where a spatial derivative of the near-field component (40) is represented as

$$\mathrm{grad}[v(x)] = \sum_{i=0}^{M-1} v_i \mathrm{grad}[P_i(x)] = \sum_{i=0}^{M-1} w_i P_i(x)$$ as a linear position of these test functions $P_i$ (42) weighted

with derivative coefficients $w_i$ (46), and where each coefficient $w_i$ (46) is calculated by $w_i = f(v_j, w_j)$ with linear effort recursively from a quantity of field coefficients $v_i$ (44) and previously determined derivative coefficients $w_j$ (46).

2. Method according to claim 1,
**characterized in that** the partitions (36) of the calculation domain are described by an unstructured grid, in particular a tetrahedral (52), prismatic (56) or mixed (66) grid.

3. Method according to one of the preceding claims,
**characterized in that** the test functions $P_i$ (42) are Legendre polynomials and/or Jacobi polynomials.

4. Method according to claim 3,
**characterized in that** for a 1D field representation with Legendre polynomials for $i=M$-1 to 0 and $\hat{v}_M = 0$, $\hat{v}_{M-1} = v_{M-1}$ the following applies recursively:

$$w_i = (2i+1)\widehat{v}_{i+1} \quad \text{and} \quad \widehat{v}_{i-1} := v_{i-1} + \frac{1}{2i+1} w_i \quad \text{for all } i>0.$$

5. Method according to one of the preceding claims, **characterized in that** for determining the electromagnetic near-field components (40) an explicit and/or implicit time integration method, in particular a Leapfrog or a Runge-Kutta timestepping method, is applied, where a termination criterion of the time integration is the achievement of a predetermined number of time steps and/or the achievement of a predetermined energy field value.

6. Computing device (10) designed for the implementation of a method according to one of the aforementioned method claims, in order to determine an electromagnetic near-field (26) of a field excitation source (28) of an electrical system (12), in particular for analysis and/or optimization of antenna radiation, of a crosstalk problem, of signal reflection/transmission, of a stray field, of an irradiation problem etc., comprising:

a partitioning device (14) for defining an *N*-part partition (36) of a calculation domain containing the system (12) and inside which the near-field (26) is to be determined;
a material distribution device (16) for defining electrical and magnetic properties of the material distribution (38) of the system (12) in each partition (36) inside the domain under consideration (62);

a source device (18) for defining at least one field excitation source (28) inside the system (12);
a field determination device (20) for determining each electromagnetic near-field component (40) inside at least one and in particular all partitions (36) by solving the Maxwell's equations, taking into account the determined material distribution (38) and the determined field excitation source (28),
**characterized in that** the field determination device (20) comprises a component determination unit (22) for ascertaining a linear position of $M$ predetermined and holonomic test functions $P_i$ (42) orthogonal to one another in respect of a scalar product and weighted with field coefficients $v_i$ (44) for each near-field component (40) and a derivative determination unit (24) for determining the spatial and/or time derivatives of each near-field component (40) necessary for solving the Maxwell's equations as a linear position of these test functions $P_i$ (42) weighted with derivative coefficients $w_i$ (46), where the derivative determination unit (24) is designed for determining, during determination of the spatial derivative of each electrical near-field component (26), each coefficient $w_i$ (46) in a linearly recursive manner from a quantity of previously determined field coefficients $v_j$ (44) and derivative coefficients $w_j$ (46), such that the determination effort of the near-field (26) of the system (12) increases in linear manner to the number $N$ of partitions (36) of the domain under consideration (62) and to the number $M$ of test functions $P_i$ (42) used in the linear position.

7. Device according to claim 6,
**characterized in that** the partitioning device (14) is designed to create an unstructured $N$-part grid, in particular a tetrahedral grid (52), a prismatic grid (56) or a mixed grid (66) for $N$-part partitioning (36) of the domain under consideration (62), and a boundary condition device (60) is designed to define electrical and magnetic boundary conditions (64) of the calculation domain.

8. Device according to one of the preceding device claims,
**characterized in that** the field determination device (20) is designed to determine at least one and in particular all electromagnetic near-field components (40) by means of a DG-FEM (Discontinuous Galerkin Finite Element Method).

9. Device according to one of the preceding device claims,
**characterized in that** the field determination device (20) comprises a time integration unit (58) designed to implement time integration of the near-field components (40) of at least one and in particular all partitions (36) preferably by means of a Leapfrog or Runge-Kutta time-stepping method.

10. Device according to one of the preceding device claims,
**characterized in that** the component determination unit (22) and the derivative determination unit (24) are designed to ascertain the test functions $P_i$ (42) as Legendre polynomials and/or Jacobi polynomials.

11. Computer program product for determining an electromagnetic near-field (26) of a field excitation source (28) of an electrical system (12), where the computer program product comprises computer program instructions on a computer-readable program memory medium, in particular a hard disk drive, CD-ROM, diskette, flash memory or similar,
**characterized in that** the computer program instructions cause at least one computer or one computing device according to one of claims 6 to 10 to implement a method according to one of the preceding method claims when the instructions are read and performed by the computer or computing device.

## Revendications

1. Procédé utilisant un ordinateur programmé en conséquence ou un dispositif de calcul conçu en conséquence (10) destiné à la détermination d'un champ proche électromagnétique (26) d'une source d'excitation de champ (28) d'un système électrique (12), en particulier pour l'analyse et/ou l'optimisation d'un rayonnement d'antenne, d'un problème de diaphonie, d'une réflexion/transmission de signaux, d'un champ de dispersion, d'un problème d'irradiation ou similaires, dans un domaine d'observation (62) englobant le système (12) et divisé en N partitionnements (36), comprenant les étapes suivantes :

- Définition des propriétés électriques et magnétiques de la répartition du matériau (38) du système (12) dans chaque partitionnement (36) du domaine d'observation (62) ;
- Définition d'au moins une source d'excitation de champ (28) au sein du système (12) ;
- Détermination des composantes du champ proche électromagnétique (40) dans au moins un partitionnement, en particulier dans tous les partitionnements (36), par résolution des équations de Maxwell du champ proche (26) en tenant compte de la répartition du matériau définie (38) et de la source d'excitation de champ définie (28),

sachant qu'une formule de Galerkin discontinue (en formulation DG-FEM) du problème du champ proche est utilisée pour résoudre des équations de Maxwell,

**caractérisé en ce que** les applications des opérations de masse, de « curl-opération » et de « trace-operation » sur la composante du champ proche (40) et requises pour le calcul de la dérivée spatiale et/ou temporelle présentent un effort de détermination linéaire par rapport au nombre $N$ des partitionnements (36) du domaine de considération (62) et par rapport au nombre $M$ des fonctions d'essai $P_i$ (42) utilisées en position linéaire, sachant que chaque composante du champ proche (40) de chaque partitionnement (36) est représentée sous la forme $v(x) = \sum_{i=0}^{M-1} v_i P_i(x)$ par une position linéaire de $M$ fonctions d'essai $P_i$ (42) prédéterminées, holonomes, mutuellement orthogonales par rapport à un produit scalaire et pondérées par des coefficients de champ $v_i$ (44), qu'une dérivée spatiale de la composante du champ proche (40) est exprimée sous la forme

$$\mathrm{grad}[v(x)] = \sum_{i=0}^{M-1} v_i \mathrm{grad}[P_i(x)] = \sum_{i=0}^{M-1} w_i P_i(x)$$ comme position linéaire de ces fonctions d'essai $P_i$ (42) pondérées par des coefficients de dérive $w_i$ (46), et que chaque coefficient $w_i$ (46) est calculé avec un effort linéaire par $w_i = f(v_j, w_j)$ de manière récursive à partir d'un ensemble de coefficients de champ $v_i$ (44) et de coefficients de dérive $w_j$ (46) déterminés auparavant.

2. Procédé selon la revendication 1,
   **caractérisé en ce que** les partitionnements (36) du domaine de calcul sont décrits par un maillage non structuré, en particulier un maillage tétraédrique (52), prismatique (56) ou mixte (66).

3. Procédé selon l'une des précédentes revendications, **caractérisé en ce que** les fonctions d'essai $P_i$ (42) sont des polynômes Legendre et/ou Jacobi.

4. Procédé selon la revendication 3,
   **caractérisé en ce que** pour une représentation de champ en 1D avec des polynômes Legendre pour $i=M$-1 jusqu'à 0 ainsi que $\hat{v}_M = 0$,
   $\hat{v}_{M-1} = v_{M-1}$ on applique récursivement :

   $w_i = (2i+1)\hat{v}_{i+1}$ et $\hat{v}_{i-1} := v_{i-1} + \dfrac{1}{2i+1} w_i$ pour tous $i>0$.

5. Procédé selon l'une des précédentes revendications, **caractérisé en ce que** pour déterminer les composantes du champ proche électromagnétique (40) il faut appliquer une méthode d'intégration temporelle explicite et/ou implicite, en particulier une méthode d'incréments temporels de Leapfrog ou de Runge-Kutta, sachant qu'un critère d'arrêt de l'intégration temporelle est l'obtention d'un nombre prédéterminé d'incréments temporels et/ou l'obtention d'une valeur prédéterminée du champ énergétique.

6. Dispositif de calcul (10) conçu pour la réalisation d'un procédé selon l'une des précédentes revendications du procédé afin de déterminer un champ proche électromagnétique (26) d'une source d'excitation de champ (28) d'un système électrique (12), en particulier pour l'analyse et/ou l'optimisation d'un rayonnement d'antenne, d'un problème de diaphonie, d'une réflexion/transmission de signaux, d'un champ de dispersion, d'un problème d'irradiation etc. comprenant :

   un dispositif de partitionnement (14) pour la définition d'un partitionnement en $N$ parties (36) d'un domaine de calcul contenant le système (12) et à l'intérieur duquel le champ proche (26) doit être déterminé ;
   un dispositif de répartition du matériau (16) pour la définition de propriétés électriques et magnétiques de la répartition du matériau (38) du système (12) dans chaque partitionnement (36) du domaine de considération (62);
   un dispositif source (18) pour la définition d'au moins une source d'excitation de champ (28) au sein du système (12);
   un dispositif de détermination du champ (20) pour la détermination de chaque composante du champ proche électromagnétique (40) dans au moins un partitionnement, en particulier tous les partitionnements (36), par résolution des équations de Maxwell en tenant compte de la répartition du matériau (38) déterminée et de la source d'excitation de champ (28) déterminée,

**caractérisé en ce que** le dispositif de détermination du champ (20) comprend une unité de détermination des composantes (22) pour la détermination d'une position linéaire des $M$ fonctions d'essai $P_i$ (42) prédéterminées, holonomes, mutuellement orthogonales par rapport à un produit scalaire et pondérées par des coefficients de champ $v_j$ (44) pour chaque composante du champ proche (40) et une unité de détermination de la dérivée (24) pour la détermination des dérivées spatiales et/ou temporelles de chaque composante du champ proche (40) requises pour résoudre les équations de Maxwell sous forme de position linéaire de ces fonctions d'essai $P_i$ (42) pondérées par des coefficients de dérive $w_i$ (46), sachant que l'unité de détermination de la dérivée (24) est conçue afin de déterminer de manière linéaire et récursive, lors de la détermination de la dérivée spatiale de chaque composante respective du champ proche électrique (26), chaque coefficient $w_i$ (46) à partir d'un ensemble de coefficients de champ $v_j$ (44) et de coefficients de dérive $w_j$ (46) déterminés au préalable, de sorte que l'effort de détermination du champ proche (26) du système (12) augmente de manière linéaire en fonction du nombre $N$ des partitionnements (36) du domaine de considération (62) et du nombre $M$ des fonctions d'essai $P_i$ (42) appliquées en position linéaire.

7.  Dispositif selon la revendication 6,
    **caractérisé en ce que** le dispositif de partitionnement (14) est conçu pour créer un maillage non structuré avec $N$ parties (52), en particulier un maillage tétraédrique (52), un maillage prismatique (56) ou un maillage mixte (66) pour le partitionnement en $N$ parties (36) du domaine de considération (62), et **en ce qu'**un dispositif de conditions limites (60) est conçu pour définir les conditions limites (64) électriques et magnétiques du domaine de calcul.

8.  Dispositif selon l'une des précédentes revendications du dispositif, **caractérisé en ce que** le dispositif de détermination du champ (20) est conçu pour déterminer au moins une composante, en particulier toutes les composantes du champ proche électromagnétique (40), à l'aide d'une méthode DG-FEM (Discontinuous Galerkin Finite Element Method).

9.  Dispositif selon l'une des précédentes revendications du dispositif, **caractérisé en ce que** le dispositif de détermination du champ (20) comprend une unité d'intégration temporelle (58) qui est conçue pour exécuter une intégration temporelle des composantes du champ proche (40) d'au moins un partitionnement, en particulier de tous les partitionnements (36), de préférence à l'aide d'une méthode à incréments temporels de Leapfrog ou de Runge Kutta.

10. Dispositif selon l'une des précédentes revendications du dispositif, **caractérisé en ce que** l'unité de détermination des composantes (22) et l'unité de détermination de la dérivée (24) sont conçues pour calculer les fonctions d'essai $P_i$ (42) sous forme de polynômes Legendre et/ou Jacobi.

11. Produit de programmation informatique destiné à la détermination d'un champ proche électromagnétique (26) d'une source d'excitation de champ (28) d'un système électrique (12), sachant que le produit de programmation informatique comprend des instructions de programmation informatique sur un support de stockage de programme pouvant être lu par un ordinateur, en particulier un disque dur, un CD-ROM, une disquette, un lecteur de mémoire Flash ou similaire, **caractérisé en ce que** les instructions de programmation informatique incitent au moins un ordinateur ou un dispositif de calcul selon l'une des revendications 6 à 10 à exécuter un procédé selon l'une des précédentes revendications du procédé lorsque les instructions sont lues et exécutées par l'ordinateur ou par le dispositif de calcul.

```
                    ┌─────────────────────────┐
                    │          Start          │
                    └─────────────────────────┘
                                 │
                                 ▼
        ┌─────────────────────────────────────────┐
   S1   │      Definiere elektrisches System,     │
        │    Materialverteilung, Randbedingungen  │
        └─────────────────────────────────────────┘
                                 │
                                 ▼
        ┌─────────────────────────────────────────┐
   S2   │        Definiere Anregungsquellen       │
        └─────────────────────────────────────────┘
                                 │
                                 ▼
        ┌─────────────────────────────────────────┐
        │          Erstelle Partitionierung       │
   S3   │    mittels tetraeder-, hexaeder-,       │
        │    polyeder-, pyramidenförmigen         │
        │      und/oder gemischten Zellen         │
        └─────────────────────────────────────────┘
                                 │
                                 ▼
        ┌─────────────────────────────────────────┐
        │      Vorinitialisiere Randwerte         │
   S4   │     und Feldkomponenten für             │
        │         Zeitschrittverfahren            │
        └─────────────────────────────────────────┘
                                 │
                                 ▼
        ┌─────────────────────────────────────────┐
        │     Zeitschrittupdate der Felder        │  S5
   ┌───▶│       zur zeitlichen Integration        │
   │    └─────────────────────────────────────────┘
   │                             │
   │                             ▼
   │                          ╱     ╲
   │         Nein          ╱  Abbruchkriterium  ╲   S6
   └──────────────────────       erreicht ?      
                          ╲                    ╱
                             ╲     ╲        ╱
                                    │ Ja
                                    ▼
        ┌─────────────────────────────────────────┐
   S7   │  Präprozessieren von abgeleiteten        │
        │    Größen aus den Feldgrößen             │
        └─────────────────────────────────────────┘
                                 │
                                 ▼
                    ┌─────────────────────────┐
                    │          Stop           │
                    └─────────────────────────┘
```

Fig. 1

Fig. 2

Fig. 3

Fig. 4

Fig. 5a

Fig. 5b

Fig. 6

Fig. 7a

Fig. 7b

Fig. 8a  52

Fig. 8b  56

TEM-Welle
$E_y$-polarisiert

28

13.75m

14.6m

2.2m

Fig. 9

74.6m  64m

62

28

73.75m

50

Fig. 10

x=10m
Fig. 11a          52, 66

x=32m
Fig. 11b          52, 66

Fig. 12          x=32m

Probe Time Signals in V/m

Fig. 13          $t$ / ns

# EP 2 378 444 B1

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Nicht-Patentliteratur**

- **VON T. WEILAND.** Eine Methode zur Lösung der Maxwellschen-Gleichungen für sechskomponentige Felder auf Diskreter Basis. *Electronics and Communication (AEÜ),* Marz 1977, vol. 31 (3), 116-120
- **VON KANE YEE.** Numerical Solution of Initial Boundary Value Problems Involving Maxwell's Equations in Isotropic Media. *Antennas and Propagation, IEEE Transactions,* 1966, vol. 14, 302-307
- **VON J. C. NÉDÉLEC.** Mixed Finite Elements in R^3. *Numerische Mathematik,* 1980, vol. 35, 315-341
- Implementation of a Discontinuous Galerkin (DG) Method for Antenna Applications. **KEERTI S. KONA.** Antennas and Propagation International Symposium. IEEE, 01. Juni 2007, 4995-4998
- **STEPHEN D. GEDNEY et al.** The Discontinuous Galerkin Finite Element Time Domain Method (DGFETD): A High Order, Globally-Explicit Method for Parallel Computation. *2002 IEEE International Symposium on Electromagnetic Compatibility. EMC. Symposium Record. Minneapolis, MN,* 19. August 2002, ISBN 978-0-7803-7264-1, 1-3
- **GOEDEL N. et al.** Local timestepping discontinuous Galerkin methods for electromagnetic Galerkin methods for electromagnetic RF field problems. *Antennas and Propagation, 2009. EUCAP 2009, 3rd European Conference on, IEEE, Piscataway, NJ, USA,* 23. Marz 2009, ISBN 978-1-4244-4753-4, 2149-2153
- **GOEDEL N. et al.** Time domain discontinuous Galerkin method with efficient modelling of boundary conditions for simulations of electromagnetic wave propagation. *Electromagnetic Compatibility and 19th International Zürich Symposium on Electromagnetic Compatibility, 2008, APEMC 2008, Asia-Pacific Symposium On, IEEE, Piscataway, NJ, USA,* 19. Mai 2008, ISBN 978-981-08-0629-3, 594-597

- Keeping Time with Maxwell's Equations. **HARALD SONGORO et al.** IEEE Microwave Magazine. IEEE Service Center, 01. April 2010, 42-49
- Nodal high-order methods on unstructured grids. I. Time-domain solution of Maxwell's equations. **VON J. S. HESTHAVEN et al.** Journal of Computational Physics. Academic Press, 01. September 2002, vol. 181, 186-221
- Nodal Discontinuous Galerkin Methods. **JAN S. HESTHAVEN ; TIM WARBURTON.** Algorithms, Analysis, and Applications. Springer Science+Business Media, LLC, 2008
- **GARY C. COHEN.** Higher-Order Numerical Methods for Transient Wave Equations. Springer, 2002
- **MOSHE DUBINER.** Spectral methods on triangles and other domains. *Journal of Scientific Computing,* 1991, vol. 6, 345-390
- **JAN S. HESTHAVEN ; TIM WARBURTON.** Nodal Discontinuous Galerkin Methods - Algorithms, Analysis, and Applications. Springer Science+Business Media, LLC, 2008
- **GEORGE EM KARNIADAKIS ; SPENCER SHERWIN.** Spectral/hp Element Methods for Computational Fluid Dynamics. Oxford Univ. Press, 2005
- **FREDERIC CHYZAK.** Fonctions holonomes en Calcul formel. *PhD thesis,* 1998
- **CHRISTOPH KOUTSCHAN.** Advanced Applications of the Holonomic Systems Approach. *PhD thesis,* 2009
- **DORON ZEILBERGER.** A holonomic systems approach to special function identities. *Journal of Computational and Applied Mathematics,* 1990, vol. 32 (3), 321-368